# EUROPEAN PATENT APPLICATION

(11) **EP 3 890 042 A1**
(43) Date of publication of application: **06.10.2021**
(21) Application number: 19888717.6
(22) Date of filing: 26.11.2019
(51) Int. Cl.: H01L 51/50

(54) **ORGANIC ELECTROLUMINESCENCE ELEMENT**

(30) Priority: 29.11.2018 JP 2018224295
(71) Applicant: Hodogaya Chemical Co., Ltd., Tokyo 104-0028 (JP)
(72) Inventor: SURUGA, Kazuyuki, Tokyo 104-0028 (JP); YAMAMOTO, Takeshi, Tokyo 104-0028 (JP); MOCHIZUKI, Shunji, Tokyo 104-0028 (JP); KASE, Kouki, Tokyo 104-0028 (JP); LIM, Jae-Geon, Tokyo 104-0028 (JP)
(74) Representative: Forstmeyer, Dietmar
(86) International application number: PCT/JP2019/046241
(87) International publication number: WO 2020/111077

(57) **Abstract**

An object of the present invention is to provide, as a material for a highly efficient and highly durable organic EL element, an organic compound having excellent hole-injecting/transporting capability, electron-blocking capability, stability in the form of a thin film, and durability. Furthermore, another object of the present invention is to provide an organic EL element having high efficiency, a low driving voltage, and a long lifespan, by combining the organic compound with various materials for organic EL elements so as to effectively exhibit the properties of the individual materials, the materials having excellent hole/electron-injecting/transporting capability, electron-blocking capability, stability in the form of a thin film, and durability. The arylamine compound having a specific structure according to the present invention has excellent hole-injecting/transporting capability, stability in the form of a film, and durability. When this arylamine compound having a specific structure is selected as the material of a hole-transporting layer, holes injected from the anode side can be efficiently transported. Furthermore, various organic EL elements including combination of the arylamine compound with an electron-transporting material having a specific structure or other materials had good element characteristics.

## Description

### Technical Field

The present invention relates to organic electroluminescence elements, which are self-light-emitting elements favorably used in various display devices, and more particularly relates to an organic electroluminescence element (hereinafter referred to simply as "organic EL element") including a specific arylamine compound.

### Background Art

Since organic EL elements are self-emissive elements, they have larger brightness and better viewability than elements including liquid crystals, and can provide a clearer display. For these reasons, active studies have been carried out on organic EL elements.

In 1987, C. W. Tang et al. of Eastman Kodak Company developed an element having a layered structure in which various functions were assigned to different materials, and thus made a practical organic EL element including organic materials. They made an organic EL element having a layered structure including a layer of a fluorescent substance capable of transporting electrons and a layer of an organic substance capable of transporting holes, and injected both charges into the layer of the fluorescent substance to thereby cause the layer to emit light, and the organic EL element thus achieved a luminance as high as 1,000 cd/m² or more at a voltage of 10 V or less (see Patent Literatures 1 and 2, for example).

Organic EL elements have been heretofore much improved to put them to practical use. Electroluminescent elements have been suggested in which an anode, a hole-injecting layer, a hole-transporting layer, a light-emitting layer, an electron-transporting layer, an electron-injecting layer, and a cathode are sequentially provided on a substrate to subdivide various functions in the multi-layered structure even further, and such electroluminescent elements successfully have high efficiency and durability (see Non-Patent Literature 1, for example).

To further increase luminous efficacy, attempts have been made to utilize triplet excitons, and the utilization of phosphorescent compounds has been investigated (see Non-Patent Literature 2, for example).

Moreover, elements that utilize light emission by thermally activated delayed fluorescence (TADF) have also been developed. In 2011, Adachi et al. from Kyushu University achieved a result of an external quantum efficiency of 5.3% by an element including a thermally activated delayed fluorescence material (see Non-Patent Literature 3, for example).

The light-emitting layer can also be prepared by doping a charge-transporting compound, generally called a host material, with a fluorescent compound, a phosphorescent compound, or a material that radiates delayed fluorescence. As stated in the non-patent literature above, the selection of the organic materials in an organic EL element greatly affects the characteristics of that element, such as efficiency and durability (see Non-Patent Literature 2, for example).

In an organic EL element, the charges injected from both electrodes recombine in the light-emitting layer, thereby producing light emission, and how efficiently the both charges, i.e., the holes and the electrons, are passed to the light-emitting layer is of importance. Thus, the element needs to have an excellent carrier balance. Also, high luminous efficacy can be achieved by increasing the probability of the recombination of holes and electrons through improving hole-injecting capability and electron-blocking capability, that is, the ability to block electrons injected from the cathode, and also by confining excitons generated in the light-emitting layer. Therefore, the functions to be fulfilled by the hole-transporting material are important, and there is a demand for a hole-transporting material having high hole-injecting capability, high hole mobility, high electron-blocking capability, and, furthermore, high durability against electrons.

Moreover, heat resistance and amorphousness of the materials are also important for element lifespan. A material with low heat resistance thermally decomposes, due to heat generated during driving the element, even at a low temperature, and thus the material deteriorates. A film made of a material with low amorphousness causes crystallization thereof even in a short period of time to result in deterioration of the element. Thus, the materials to be used are required to have high heat resistance and good amorphousness.

N,N'-diphenyl-N,N'-di(α-naphthyl)benzidine (NPD) and various aromatic amine derivatives are known as hole-transporting materials that have been heretofore used for organic EL elements (see Patent Literatures 1 and 2, for example). NPD has good hole-transporting capability, but has a glass transition point (Tg), which is a measure of heat resistance, as low as 96°C. Such a glass transition point cause a deterioration of the element characteristics due to crystallization of NPD under high-temperature conditions (see Non-Patent Literature 4, for example). In addition, although the aromatic amine derivatives disclosed in Patent Literatures 1 and 2 include compounds having an excellent hole mobility of 10⁻³ cm²/Vs or higher, the electron-blocking capability thereof is insufficient. Thus, when using such a compound, some electrons pass through the light-emitting layer, and unfortunately, no increase in luminous efficacy can be expected. Thus, materials that have higher electron-blocking capability, higher stability in the form of a thin film, and higher heat resistance are needed in order to further increase the efficacy. Furthermore, even though aromatic amine derivatives with high durability have been reported (see Patent Literature 3, for example), these aromatic amine derivatives are used as charge-transporting materials for a photoconductor for electrophotography, and there are no precedents of application to an organic EL element.

Arylamine compounds having a substituted carbazole structure have been suggested as compounds improved in the properties including heat resistance and hole-injecting capability (see Patent Literatures 4 and 5, for example). Elements having a hole-injecting layer or a hole-transporting layer including such a compound have improved properties including heat resistance and luminous efficacy; however these properties are still insufficient. Therefore, there is a demand for a further decrease in driving voltage and a further increase in luminous efficacy.

In view of improving the characteristics of organic EL elements and also improving the production yield of elements, it is required to combine materials that are excellent in hole and electron injecting/transporting capability, stability in the form of a thin film, and durability to obtain an element that enables the recombination of holes and electrons highly efficiently and has high luminous efficacy, a low driving voltage, and a long lifespan.

Also, in view of improving the characteristics of organic EL elements, it is required to combine materials that are excellent in hole and electron injecting/transporting capability, stability in the form of a thin film, and durability to obtain an element that has a good carrier balance as well as high efficiency, a low driving voltage, and a long lifespan.

### Citation List

### Patent Literature

Patent Literature 1: US 5792557
Patent Literature 2: US 5639914
Patent Literature 3: US 7799492
Patent Literature 4: US 8021764
Patent Literature 5: US 8394510
Patent Literature 6: KR 10-2013-0060157A
Patent Literature 7: KR 10-2015-0130206A
Patent Literature 8: EP 2684932

### Non-Patent Literature

Non-Patent Literature 1: Proceedings of the 9th Meeting of the Japan Society of Applied Physics, pp. 55-61 (2001)
Non-Patent Literature 2: Proceedings of the 9th Meeting of the Japan Society of Applied Physics, pp. 23-31 (2001)
Non-Patent Literature 3: Appl. Phys. Let., 98, 083302 (2011)
Non-Patent Literature 4: Proceedings of the 3rd Meeting of Japan OLED Forum, pp. 13-14 (2006)

### Summary of Invention

An object of the present invention is to provide, as a material for a highly efficient and highly durable organic EL element, an organic compound having excellent hole-injecting/transporting capability, electron-blocking capability, stability in the form of a thin film, and durability. Furthermore, another object of the present invention is to provide an organic EL element having high efficiency, a low driving voltage, and a long lifespan, by combining the organic compound with various materials for organic EL elements so as to effectively exhibit the properties of the individual materials, the materials having excellent hole and electron-injecting/transporting capability, electron-blocking capability, stability in the form of a thin film, and durability,.

An organic compound to be provided by the present invention should have the following physical properties: (1) good hole-injecting properties, (2) high hole mobility, (3) good stability in the form of a thin film, and (4) excellent heat resistance.

Also, an organic EL element to be provided by the present invention should have the following physical characteristics: (1) high luminous efficacy and high power efficiency, (2) a low voltage for the start of light emission, (3) a low driving voltage in actual use, and (4) a long lifespan.

To achieve the above-described objects, the inventors of the present invention focused on the fact that an arylamine compound having a specific structure has excellent hole-injecting/transporting capability, thin film stability, and durability, and have fabricated organic EL elements by selecting and using various arylamine compounds, followed by thoroughly evaluating the characteristics of the resulting organic EL elements. As a result, the inventors of the present invention have found that efficient transport of holes injected from the anode side can be achieved when an arylamine compound having a specific structure is selected as the material of a hole-transporting layer. Furthermore, the inventors of the present invention have fabricated various organic EL elements by combining with, for example, an electron-transporting material having a specific structure, followed by thoroughly evaluating the characteristics of the resulting organic EL elements, and thus, the present invention has been accomplished.

Specifically, the present invention provides the following organic EL element.
1) An organic EL element having at least an anode, a hole-transporting layer, a light-emitting layer, an electron-transporting layer, and a cathode in this order, the hole-transporting layer containing an arylamine compound represented by the general formula (1): 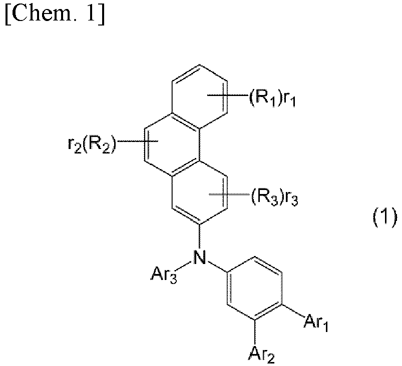
   where R₁ to R₃ each independently represent a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
   Ar₁ to Ar₃ each independently represent a substituted or unsubstituted aromatic hydrocarbon group, a substituted or unsubstituted aromatic heterocyclic group, or a substituted or unsubstituted fused polycyclic aromatic group; and
   r₁ represents an integer of 0 to 4, r₂ represents an integer of 0 to 2, and r₃ represents an integer of 0 to 3,
   where, when r₁ is an integer of 2 to 4, when r₂ is 2, or when r₃ is an integer of 2 or 3, a plurality of groups R₁ to R₃ bonded to the same benzene ring are the same or different from each other.
2) The organic EL element as set forth in clause 1), wherein the arylamine compound is a compound represented by the general formula (1a): 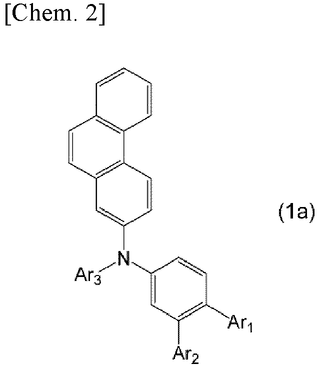 where Ar₁ to Ar₃ are as defined in the general formula (1).
3) The organic EL element as set forth in clause 2), wherein Ar₃ is a substituted or unsubstituted phenyl group.
4) The organic EL element as set forth in clause 1), wherein the arylamine compound is represented by the general formula (1b): 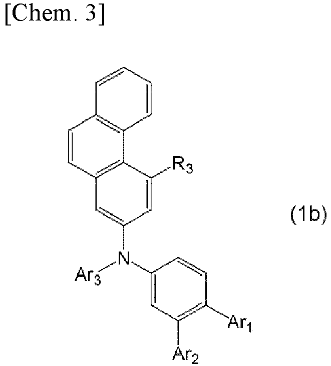 where R₃ and Ar₁ to Ar₃ are as defined in the general formula (1).
5) The organic electroluminescence element as set forth in clause 4), wherein Ar₃ is a substituted or unsubstituted phenyl group.
6) The organic EL element as set forth in any one of clauses 1) to 5), wherein the electron-transporting layer contains a compound having a pyrimidine ring structure and being represented by the general formula (2): 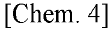 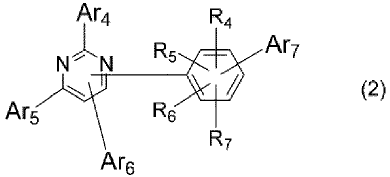
   where Ar₄ represents a substituted or unsubstituted aromatic hydrocarbon group or a substituted or unsubstituted fused polycyclic aromatic group;
   Ar₅ and Ar₆ each independently represent a hydrogen atom, a substituted or unsubstituted aromatic hydrocarbon group, or a substituted or unsubstituted fused polycyclic aromatic group, where there is no case that both Ar₅ and Ar₆ are hydrogen atoms;
   Ar₇ represents a substituted or unsubstituted aromatic heterocyclic group; and
   R₄ to R₇ each independently represent a hydrogen atom, a deuterium atom, a fluorine atom, a chlorine atom, a cyano group, a trifluoromethyl group, a linear or branched alkyl group having 1 to 6 carbon atoms, a substituted or unsubstituted aromatic hydrocarbon group, a substituted or unsubstituted aromatic heterocyclic group, or a substituted or unsubstituted fused polycyclic aromatic group.
7) The organic EL element as set forth in any one of clauses 1) to 6), wherein the hole-transporting layer has a two-layer structure consisting of a first hole-transporting layer and a second hole-transporting layer, and the second hole-transporting layer is adjacent to the light-emitting layer and contains the arylamine compound.
8) The organic EL element as set forth in clause 7), wherein the first hole-transporting layer contains a triphenylamine derivative which is different from the arylamine compound contained in the second hole-transporting layer, the triphenylamine derivative is a compound having a molecular structure in which two triphenylamine skeletons are linked to each other via a single bond or a divalent hydrocarbon group, and the triphenylamine derivative has two to six triphenylamine skeletons in the molecule as a whole.
9) The organic EL element as set forth in clause 7) or 8), wherein the triphenylamine derivative contained in the first hole-transporting layer is a compound represented by the general formula (3): 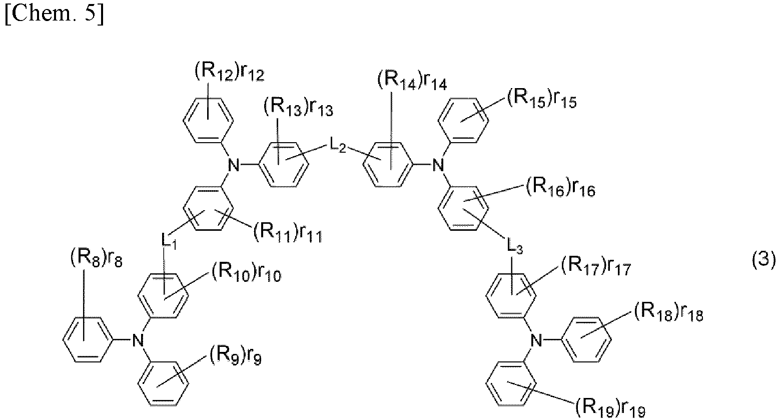
   where R₈ to R₁₉ each independently represent a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
   r₈, r₉, r₁₂, r₁₅, r₁₈, and r₁₉ each independently represent an integer of 0 to 5, and r₁₀, r₁₁, r₁₃, r₁₄, r₁₆, and r₁₇ each independently represent an integer of 0 to 4,
   where, when r₈, r₉, r₁₂, r₁₅, r₁₈, or r₁₉ is an integer of 2 to 5, or when r₁₀, r₁₁, r₁₃, r₁₄, r₁₆, or r₁₇ is an integer of 2 to 4, a plurality of groups R₈ to R₁₉ bonded to the same benzene ring are the same or different from each other, and are optionally bonded to each other via a single bond, a substituted or unsubstituted methylene group, an oxygen atom, or a sulfur atom to form a ring; and
   L₁, L₂, and L₃ each independently represent a divalent group represented by any one of the structural formulae (B) to (G), or a single bond: 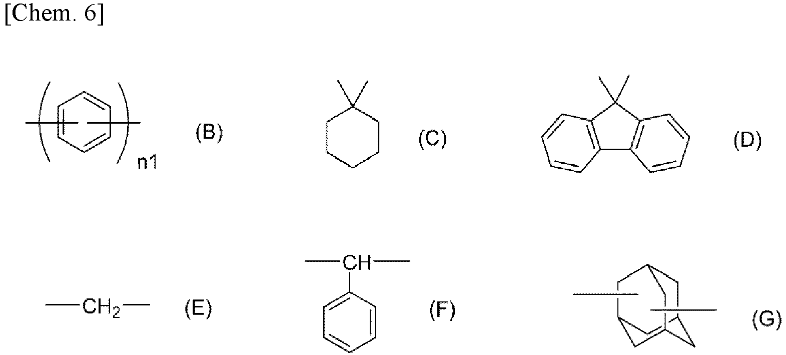 where n1 represents an integer of 1 to 3.
10) The organic EL element as set forth in clause 7) or 8), wherein the triphenylamine derivative contained in the first hole-transporting layer is a compound represented by the general formula (4): 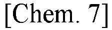 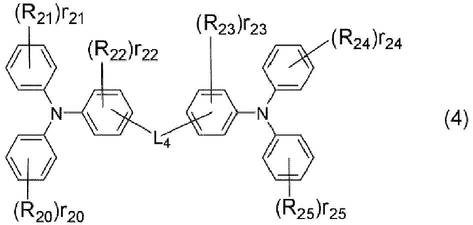
   where R₂₀ to R₂₅ each independently represent a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
   r₂₀, r₂₁, r₂₄, and r₂₅ each independently represent an integer of 0 to 5, and r₂₂ and r₂₃ each independently represent an integer of 0 to 4,
   where, when r₂₀, r₂₁, r₂₄, or r₂₅ is an integer of 2 to 5, or when r₂₂ or r₂₃ is an integer of 2 to 4, a plurality of groups R₂₀ to R₂₅ bonded to the same benzene ring are the same or different from each other, and are optionally bonded to each other via a single bond, a substituted or unsubstituted methylene group, an oxygen atom, or a sulfur atom to form a ring; and
   L₄ represents a divalent group represented by any one of the structural formulae (B) to (G), or a single bond: 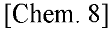 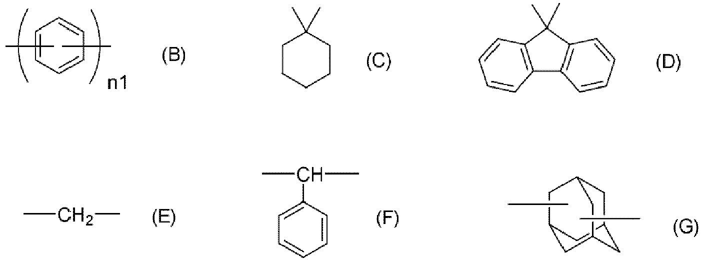 where n1 represents an integer of 1 to 3.
11) The organic EL element as set forth in any one of clauses 1) to 10), wherein the light-emitting layer contains a blue light-emitting dopant.
12) The organic EL element as set forth in clause 11), wherein the blue light-emitting dopant is a pyrene derivative having a pyrene skeleton in the molecule.
13) The organic EL element as set forth in clause 11), wherein the blue light-emitting dopant is an amine derivative having a fused ring structure and represented by the general formula (5): 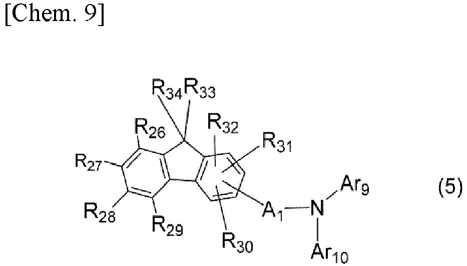
   where A₁ represents a divalent group of a substituted or unsubstituted aromatic hydrocarbon, a divalent group of a substituted or unsubstituted aromatic heterocycle, a divalent group of a substituted or unsubstituted fused polycyclic aromatic compound, or a single bond;
   Ar₉ and Ar₁₀ each independently represent a substituted or unsubstituted aromatic hydrocarbon group, a substituted or unsubstituted aromatic heterocyclic group, or a substituted or unsubstituted fused polycyclic aromatic group, and are optionally bonded to each other via a single bond, a substituted or unsubstituted methylene group, an oxygen atom, or a sulfur atom to form a ring;
   R₂₆ to R₂₉ each independently represent a hydrogen atom, a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, a substituted or unsubstituted aryloxy group, or a di-substituted amino group having substituents selected from an aromatic hydrocarbon group, an aromatic heterocyclic group, and a fused polycyclic aromatic group,
   where the groups represented by R₂₆ to R₂₉ are optionally bonded to each other via a single bond, a substituted or unsubstituted methylene group, an oxygen atom, or a sulfur atom to form a ring, and are optionally bonded, via a substituted or unsubstituted methylene group, an oxygen atom, a sulfur atom, or a monosubstituted amino group, to the benzene ring to which R₂₆ to R₂₉ are bonded to form a ring;
   R₃₀ to R₃₂ each independently represent a hydrogen atom, a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group,
   where the groups represented by R₃₀ to R₃₂ are optionally bonded to each other via a single bond, a substituted or unsubstituted methylene group, an oxygen atom, or a sulfur atom to form a ring, and are optionally bonded, via a substituted or unsubstituted methylene group, an oxygen atom, a sulfur atom, or a monosubstituted amino group, to the benzene ring to which R₃₀ to R₃₂ are bonded to form a ring; and
   R₃₃ and R₃₄ each independently represent a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group,
   where the groups represented by R₃₃ and R₃₄ are optionally bonded to each other via a single bond, a substituted or unsubstituted methylene group, an oxygen atom, a sulfur atom, or a monosubstituted amino group to form a ring.
14) The organic EL element as set forth in any one of clauses 1) to 13), wherein the light-emitting layer contains an anthracene derivative having an anthracene skeleton in the molecule.
15) The organic EL element as set forth in clause 14), wherein the light-emitting layer contains the anthracene derivative a host material.

Specific examples of the "linear or branched alkyl group having 1 to 6 carbon atoms", the "cycloalkyl group having 5 to 10 carbon atoms", or the " linear or branched alkenyl group having 2 to 6 carbon atoms" of the "linear or branched alkyl group having 1 to 6 carbon atoms and optionally having a substituent", the "cycloalkyl group having 5 to 10 carbon atoms and optionally having a substituent", or the "linear or branched alkenyl group having 2 to 6 carbon atoms and optionally having a substituent" represented by R₁ to R₃ in the general formula (1) include: a methyl group, an ethyl group, an n-propyl group, an isopropyl group, an n-butyl group, an isobutyl group, a tert-butyl group, an n-pentyl group, an isopentyl group, a neopentyl group, an n-hexyl group, a cyclopentyl group, a cyclohexyl group, a 1-adamantyl group, a 2-adamantyl group, a vinyl group, an allyl group, an isopropenyl group, and a 2-butenyl group.

Specific examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₁ to R₃ in the general formula (1) include: a deuterium atom, a cyano group, and a nitro group; halogen atoms such as a fluorine atom, a chlorine atom, a bromine atom, and an iodine atom; linear or branched alkyloxy groups having 1 to 6 carbon atoms such as a methyloxy group, an ethyloxy group, and a propyloxy group; alkenyl groups such as a vinyl group and an allyl group; aryloxy groups such as a phenyloxy group and a tolyloxy group; arylalkyloxy groups such as a benzyloxy group and a phenethyloxy group; aromatic hydrocarbon groups and fused polycyclic aromatic groups such as a phenyl group, a biphenylyl group, a terphenylyl group, a naphthyl group, an anthracenyl group, a phenanthrenyl group, a fluorenyl group, an indenyl group, a pyrenyl group, a perylenyl group, a fluoranthenyl group, and a triphenylenyl group; aromatic heterocyclic groups such as a pyridyl group, a pyrimidinyl group, a triazinyl group, a thienyl group, a furyl group, a pyrrolyl group, a quinolyl group, an isoquinolyl group, a benzofuranyl group, a benzothienyl group, an indolyl group, a carbazolyl group, a benzooxazolyl group, a benzothiazolyl group, a quinoxalinyl group, a benzimidazolyl group, a pyrazolyl group, a dibenzofuranyl group, a dibenzothienyl group, and a carbolinyl group; di-substituted amino groups having substituents selected from an aromatic hydrocarbon group and a fused polycyclic aromatic group, such as a diphenylamino group and a dinaphthylamino group; di-substituted amino groups having two aromatic heterocyclic groups, such as a dipyridylamino group and a dithienylamino group; and di-substituted amino groups having substituents selected from an aromatic hydrocarbon group, a fused polycyclic aromatic group, and an aromatic heterocyclic group. These substituents may further be substituted by any of the substituents listed above.

Specific examples of the "linear or branched alkyloxy group having 1 to 6 carbon atoms" or the "cycloalkyloxy group having 5 to 10 carbon atoms" of the "linear or branched alkyloxy group having 1 to 6 carbon atoms and optionally having a substituent" or the "cycloalkyloxy group having 5 to 10 carbon atoms and optionally having a substituent" represented by R₁ to R₃ in the general formula (1) include: a methyloxy group, an ethyloxy group, an n-propyloxy group, an isopropyloxy group, an n-butyloxy group, a tert-butyloxy group, an n-pentyloxy group, an n-hexyloxy group, a cyclopentyloxy group, a cyclohexyloxy group, a cycloheptyloxy group, a cyclooctyloxy group, a 1-adamantyloxy group, and a 2-adamantyloxy group.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₁ to R₃ in the general formula (1).

Specific examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₁ to R₃ in the general formula (1) include: a phenyl group, a biphenylyl group, a terphenylyl group, a naphthyl group, an anthracenyl group, a phenanthrenyl group, a fluorenyl group, an indenyl group, a pyrenyl group, a perylenyl group, a fluoranthenyl group, a triphenylenyl group, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzooxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, and a carbolinyl group.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₁ to R₃ in the general formula (1). In addition, examples of the substituent further include those listed above as examples of the "linear or branched alkyl group having 1 to 6 carbon atoms", the "cycloalkyl group having 5 to 10 carbon atoms", or the " linear or branched alkenyl group having 2 to 6 carbon atoms" represented by R₁ to R₃ in the general formula (1).

Specific examples of the "aryloxy group" of the "substituted or unsubstituted aryloxy group" represented by R₁ to R₃ in the general formula (1) include: a phenyloxy group, a biphenylyloxy group, a terphenylyloxy group, a naphthyloxy group, an anthracenyloxy group, a phenanthrenyloxy group, a fluorenyloxy group, an indenyloxy group, a pyrenyloxy group, and a perylenyloxy group.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₁ to R₃ in the general formula (1). In addition, examples of the substituent further include those listed above as examples of the "linear or branched alkyl group having 1 to 6 carbon atoms", the "cycloalkyl group having 5 to 10 carbon atoms", or the " linear or branched alkenyl group having 2 to 6 carbon atoms" represented by R₁ to R₃ in the general formula (1).

Specific examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by Ar₁ to Ar₃ in the general formula (1) include: a phenyl group, a biphenylyl group, a terphenylyl group, a naphthyl group, an anthracenyl group, a phenanthrenyl group, a fluorenyl group, an indenyl group, a pyrenyl group, a perylenyl group, a fluoranthenyl group, a triphenylenyl group, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzooxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, and a carbolinyl group.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₁ to R₃ in the general formula (1).

Specific examples of the "aromatic hydrocarbon group" or the "fused polycyclic aromatic group" of the "substituted or unsubstituted aromatic hydrocarbon group" or the "substituted or unsubstituted fused polycyclic aromatic group" represented by Ar₄ to Ar₆ in the general formula (2) include: a phenyl group, a biphenylyl group, a terphenylyl group, a quaterphenyl group, a styryl group, a naphthyl group, an anthracenyl group, an acenaphthenyl group, a phenanthrenyl group, a fluorenyl group, an indenyl group, a pyrenyl group, a perylenyl group, a fluoranthenyl group, and a triphenylenyl group.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₁ to R₃ in the general formula (1). These substituents may be bonded to each other via a single bond, a substituted or unsubstituted methylene group, an oxygen atom, or a sulfur atom to form a ring.

Specific examples of the "aromatic heterocyclic group" of the "substituted or unsubstituted aromatic heterocyclic group" represented by Ar₇ in the general formula (2) include: a triazinyl group, a pyridyl group, a pyrimidinyl group, a furyl group, a pyrrolyl group, a thienyl group, a quinolyl group, an isoquinolyl group, a benzofuranyl group, a benzothienyl group, an indolyl group, a carbazolyl group, a benzooxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, and a carbolinyl group.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₁ to R₃ in the general formula (1). These substituents may be bonded to each other via a single bond, a substituted or unsubstituted methylene group, an oxygen atom, or a sulfur atom to form a ring.

Specific examples of the "linear or branched alkyl group having 1 to 6 carbon atoms" represented by R₄ to R₇ in the general formula (2) include: a methyl group, an ethyl group, an n-propyl group, an i-propyl group, an n-butyl group, a 2-methylpropyl group, a t-butyl group, an n-pentyl group, a 3-methylbutyl group, a tert-pentyl group, a n-hexyl group, an iso-hexyl group, and a tert-hexyl group.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₁ to R₃ in the general formula (1). These substituents may be bonded to each other via a single bond, a substituted or unsubstituted methylene group, an oxygen atom, or a sulfur atom to form a ring.

Specific examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₄ to R₇ in the general formula (2) include: a phenyl group, a biphenylyl group, a terphenylyl group, a quaterphenyl group, a styryl group, a naphthyl group, an anthracenyl group, an acenaphthenyl group, a phenanthrenyl group, a fluorenyl group, an indenyl group, a pyrenyl group, a perylenyl group, a fluoranthenyl group, a triphenylenyl group, a triazinyl group, a pyridyl group, a pyrimidinyl group, a furyl group, a pyrrolyl group, a thienyl group, a quinolyl group, an isoquinolyl group, a benzofuranyl group, a benzothienyl group, an indolyl group, a carbazolyl group, a benzooxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, and a carbolinyl group.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₁ to R₃ in the general formula (1). These substituents may be bonded to each other via a single bond, a substituted or unsubstituted methylene group, an oxygen atom, or a sulfur atom to form a ring.

Specific examples of the "linear or branched alkyl group having 1 to 6 carbon atoms", the "cycloalkyl group having 5 to 10 carbon atoms", or the "linear or branched alkenyl group having 2 to 6 carbon atoms" of the "linear or branched alkyl group having 1 to 6 carbon atoms and optionally having a substituent", the "cycloalkyl group having 5 to 10 carbon atoms and optionally having a substituent", or the "linear or branched alkenyl group having 2 to 6 carbon atoms and optionally having a substituent" represented by R₈ to R₁₉ in the general formula (3) include: a methyl group, an ethyl group, an n-propyl group, an isopropyl group, an n-butyl group, an isobutyl group, a tert-butyl group, an n-pentyl group, an isopentyl group, a neopentyl group, an n-hexyl group, a cyclopentyl group, a cyclohexyl group, a 1-adamantyl group, a 2-adamantyl group, a vinyl group, an allyl group, an isopropenyl group, and a 2-butenyl group. Also, when a plurality of groups are bonded, as groups R₈, R₉, R₁₀, R₁₁, R₁₂, R₁₃, R₁₄, R₁₅, R₁₆, R₁₇, R₁₈, or R₁₉, to the same benzene ring (when r₈, r₉, r₁₂, r₁₅, r₁₈, or r₁₉ is an integer of 2 to 5, or when r₁₀, r₁₁, r₁₃, r₁₄, r₁₆, or r₁₇ is an integer of 2 to 4), these groups may be bonded to each other via a single bond, a substituted or unsubstituted methylene group, an oxygen atom, or a sulfur atom to form a ring.

Specific examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3) include: a deuterium atom, a cyano group, and a nitro group; halogen atoms such as a fluorine atom, a chlorine atom, a bromine atom, and an iodine atom; linear or branched alkyloxy groups having 1 to 6 carbon atoms such as a methyloxy group, an ethyloxy group, and a propyloxy group; alkenyl groups such as a vinyl group and an allyl group; aryloxy groups such as a phenyloxy group and a tolyloxy group; arylalkyloxy groups such as a benzyloxy group and a phenethyloxy group; aromatic hydrocarbon groups or fused polycyclic aromatic groups such as a phenyl group, a biphenylyl group, a terphenylyl group, a naphthyl group, an anthracenyl group, a phenanthrenyl group, a fluorenyl group, an indenyl group, a pyrenyl group, a perylenyl group, a fluoranthenyl group, and a triphenylenyl group; and aromatic heterocyclic groups such as a pyridyl group, a pyrimidinyl group, a triazinyl group, a thienyl group, a furyl group, a pyrrolyl group, a quinolyl group, an isoquinolyl group, a benzofuranyl group, a benzothienyl group, an indolyl group, a carbazolyl group, a benzooxazolyl group, a benzothiazolyl group, a quinoxalinyl group, a benzimidazolyl group, a pyrazolyl group, a dibenzofuranyl group, a dibenzothienyl group, and a carbolinyl group. These substituents may further be substituted by any of the substituents listed above. Also, these substituents may be bonded to each other via a single bond, a substituted or unsubstituted methylene group, an oxygen atom, or a sulfur atom to form a ring.

Specific examples of the "linear or branched alkyloxy group having 1 to 6 carbon atoms" or the "cycloalkyloxy group having 5 to 10 carbon atoms" of the "linear or branched alkyloxy group having 1 to 6 carbon atoms and optionally having a substituent" or the "cycloalkyloxy group having 5 to 10 carbon atoms and optionally having a substituent" represented by R₈ to R₁₉ in the general formula (3) include: a methyloxy group, an ethyloxy group, an n-propyloxy group, an isopropyloxy group, an n-butyloxy group, a tert-butyloxy group, an n-pentyloxy group, an n-hexyloxy group, a cyclopentyloxy group, a cyclohexyloxy group, a cycloheptyloxy group, a cyclooctyloxy group, a 1-adamantyloxy group, and a 2-adamantyloxy group. Also, when a plurality of groups are bonded, as groups R₈, R₉, R₁₀, R₁₁, R₁₂, R₁₃, R₁₄, R₁₅, R₁₆, R₁₇, R₁₈, or R₁₉, to the same benzene ring (when r₈, r₉, r₁₂, r₁₅, r₁₈, or r₁₉ is an integer of 2 to 5, or when r₁₀, r₁₁, r₁₃, r₁₄, r₁₆, or r₁₇ is an integer of 2 to 4), these groups may be bonded to each other via a single bond, a substituted or unsubstituted methylene group, an oxygen atom, or a sulfur atom to form a ring.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

Specific examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₈ to R₁₉ in the general formula (3) include: a phenyl group, a biphenylyl group, a terphenylyl group, a naphthyl group, an anthracenyl group, a phenanthrenyl group, a fluorenyl group, an indenyl group, a pyrenyl group, a perylenyl group, a fluoranthenyl group, a triphenylenyl group, a pyridyl group, a furyl group, a pyrrolyl group, a thienyl group, a quinolyl group, an isoquinolyl group, a benzofuranyl group, a benzothienyl group, an indolyl group, a carbazolyl group, a benzooxazolyl group, a benzothiazolyl group, a quinoxalinyl group, a benzimidazolyl group, a pyrazolyl group, a dibenzofuranyl group, a dibenzothienyl group, and a carbolinyl group. Also, when a plurality of groups are bonded, as groups R₈, R₉, R₁₀, R₁₁, R₁₂, R₁₃, R₁₄, R_{1S}, R₁₆, R₁₇, R₁₈, or R₁₉, to the same benzene ring (when r₈, r₉, r₁₂, r₁₅, r₁₈, or r₁₉ is an integer of 2 to 5, or when r₁₀, r₁₁, r₁₃, r₁₄, r₁₆, or r₁₇ is an integer of 2 to 4), these groups may be bonded to each other via a single bond, a substituted or unsubstituted methylene group, an oxygen atom, or a sulfur atom to form a ring.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

Specific examples of the "aryloxy group" of the "substituted or unsubstituted aryloxy group" represented by R₈ to R₁₉ in the general formula (3) include: a phenyloxy group, a biphenylyloxy group, a terphenylyloxy group, a naphthyloxy group, an anthracenyloxy group, a phenanthrenyloxy group, a fluorenyloxy group, an indenyloxy group, a pyrenyloxy group, and a perylenyloxy group. Also, when a plurality of groups are bonded, as groups R₈, R₉, R₁₀, R₁₁, R₁₂, R₁₃, R₁₄, R₁₅, R₁₆, R₁₇, R₁₈, or R₁₉, to the same benzene ring (when r₈, r₉, r₁₂, r₁₅, r₁₈, or r₁₉ is an integer of 2 to 5, or when r₁₀, r₁₁, r₁₃, r₁₄, r₁₆, or r₁₇ is an integer of 2 to 4), these groups may be bonded to each other via a single bond, a substituted or unsubstituted methylene group, an oxygen atom, or a sulfur atom to form a ring.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

In the general formula (3), r₈, r₉, r₁₂, r₁₅, r₁₈, and r₁₉ each independently represent an integer of 0 to 5, and r₁₀, r₁₁, r₁₃, r₁₄, r₁₆, and r₁₇ each independently represent an integer of 0 to 4. When r₈, r₉, r₁₀, r₁₁, r₁₂, r₁₃, r₁₄, r₁₅, r₁₆, r₁₇, r₁₈, or r₁₉ is 0, it means that R₈, R₉, R₁₀, R_{11,} R₁₂, R₁₃, R₁₄, R₁₅, R₁₆, R₁₇, R₁₈, or R₁₉ is not present on the benzene ring, that is, the benzene ring is not substituted by the group represented by R₈, R₉, R₁₀, R₁₁, R₁₂, R₁₃, R₁₄, R₁₅, R₁₆, R₁₇, R₁₈, or R₁₉.

In the structural formula (B) in the general formula (3), n1 represents an integer of 1 to 3.

Examples of the "linear or branched alkyl group having 1 to 6 carbon atoms", the "cycloalkyl group having 5 to 10 carbon atoms", or the "linear or branched alkenyl group having 2 to 6 carbon atoms" of the "linear or branched alkyl group having 1 to 6 carbon atoms and optionally having a substituent", the "cycloalkyl group having 5 to 10 carbon atoms and optionally having a substituent", or the "linear or branched alkenyl group having 2 to 6 carbon atoms and optionally having a substituent" represented by R₂₀ to R₂₅ in the general formula (4) include those listed above as examples of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these groups may be in.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents can take.

Examples of the "linear or branched alkyloxy group having 1 to 6 carbon atoms" or the "cycloalkyloxy group having 5 to 10 carbon atoms" of the "linear or branched alkyloxy group having 1 to 6 carbon atoms and optionally having a substituent" or the "cycloalkyloxy group having 5 to 10 carbon atoms and optionally having a substituent" represented by R₂₀ to R₂₅ in the general formula (4) include those listed above as examples of the "linear or branched alkyloxy group having 1 to 6 carbon atoms" or the "cycloalkyloxy group having 5 to 10 carbon atoms" of the "linear or branched alkyloxy group having 1 to 6 carbon atoms and optionally having a substituent" or the "cycloalkyloxy group having 5 to 10 carbon atoms and optionally having a substituent" represented by R₈ to R₁₉ in the general formula (3). The same holds true for the forms that these groups may be in.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

Examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₂₀ to R₂₅ in the general formula (4) include those listed above as examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₈ to R₁₉ in the general formula (3). Also, when a plurality of groups are bonded, as groups R₈, R₉, R₁₀, R₁₁, R₁₂, R₁₃, R₁₄, R₁₅, R₁₆, R₁₇, R₁₈, or R₁₉, to the same benzene ring (when r₁₇, r₁₈, r₂₁, or r₂₂ is an integer of 2 to 5, or when r₁₉ or r₂₀ is an integer of 2 to 4), these groups may be bonded to each other via a single bond, a substituted or unsubstituted methylene group, an oxygen atom, or a sulfur atom to form a ring.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

Examples of the "aryloxy group" of the "substituted or unsubstituted aryloxy group" represented by R₂₀ to R₂₅ in the general formula (4) include those listed above as examples of the "aryloxy group" of the "substituted or unsubstituted aryloxy group" represented by R₈ to R₁₉ in the general formula (3). The same holds true for the forms that these groups may be in.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

In the general formula (4), r₂₀, r₂₁, r₂₄, and r₂₅ each independently represent an integer of 0 to 5, and r₂₂ and r₂₃ each independently represent an integer of 0 to 4. When r₂₀, r₂₁, r₂₂, r₂₃, r₂₄, or r₂₅ is 0, it means that R₂₀, R₂₁, R₂₂, R₂₃, R₂₄, or R₂₅ is not present on the benzene ring, that is, the benzene ring is not substituted by the group represented by R₂₀, R₂₁, R₂₂, R₂₃, R₂₄, or R₂₅.

In the structural formula (B) in the general formula (4), n1 represents an integer of 1 to 3.

Specific examples of the "aromatic hydrocarbon", the "aromatic heterocycle", or the "fused polycyclic aromatic compound" of the "substituted or unsubstituted aromatic hydrocarbon", the "substituted or unsubstituted aromatic heterocycle", or the "substituted or unsubstituted fused polycyclic aromatic compound" of the "divalent group of a substituted or unsubstituted aromatic hydrocarbon", the "divalent group of a substituted or unsubstituted aromatic heterocycle", or the "divalent group of a substituted or unsubstituted fused polycyclic aromatic compound" represented by A₁ in the general formula (5) include: benzene, biphenyl, terphenyl, tetrakisphenyl, styrene, naphthalene, anthracene, acenaphthalene, fluorene, phenanthrene, indan, pyrene, triphenylene, pyridine, pyrimidine, triazine, pyrrole, furan, thiophene, quinoline, isoquinoline, benzofuran, benzothiophene, indoline, carbazole, carboline, benzoxazole, benzothiazole, quinoxaline, benzoimidazole, pyrazole, dibenzofuran, dibenzothiophene, naphthyridine, phenanthroline, and acridine.

The "divalent group of a substituted or unsubstituted aromatic hydrocarbon", the "divalent group of a substituted or unsubstituted aromatic heterocycle", or the "divalent group of a substituted or unsubstituted fused polycyclic aromatic compound" represented by A₁ in the general formula (5) means a divalent group obtained by removing two hydrogen atoms from the above-described "aromatic hydrocarbon", "aromatic heterocycle", or "fused polycyclic aromatic compound".

In addition, these divalent groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

Examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by Ar₉ and Ar₁₀ in the general formula (5) include those listed above as examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₈ to R₁₉ in the general formula (3), and Ar₉ and Ar₁₀ may be bonded to each other via a single bond, a substituted or unsubstituted methylene group, an oxygen atom, or a sulfur atom to form a ring.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

Examples of the "linear or branched alkyl group having 1 to 6 carbon atoms", the "cycloalkyl group having 5 to 10 carbon atoms", or the " linear or branched alkenyl group having 2 to 6 carbon atoms" of the "linear or branched alkyl group having 1 to 6 carbon atoms and optionally having a substituent", the "cycloalkyl group having 5 to 10 carbon atoms and optionally having a substituent", or the "linear or branched alkenyl group having 2 to 6 carbon atoms and optionally having a substituent" represented by R₂₆ to R₃₄ in the general formula (5) include those listed above as examples of the "linear or branched alkyl group having 1 to 6 carbon atoms", the "cycloalkyl group having 5 to 10 carbon atoms", or the " linear or branched alkenyl group having 2 to 6 carbon atoms" of the "linear or branched alkyl group having 1 to 6 carbon atoms and optionally having a substituent", the "cycloalkyl group having 5 to 10 carbon atoms and optionally having a substituent", or the "linear or branched alkenyl group having 2 to 6 carbon atoms and optionally having a substituent" represented by R₈ to R₁₉ in the general formula (3), and these groups may be bonded to each other via a linking group such as a single bond, a substituted or unsubstituted methylene group, an oxygen atom, a sulfur atom, or a monosubstituted amino group to form a ring.

Also, these groups may have a substituent, and examples of the substituent include those listed above as examples of the "substituent" of the "linear or branched alkyl group having 1 to 6 carbon atoms and optionally having a substituent", the "cycloalkyl group having 5 to 10 carbon atoms and optionally having a substituent", or the "linear or branched alkenyl group having 2 to 6 carbon atoms and optionally having a substituent" represented by R₈ to R₁₉ in the general formula (3). The same holds true for the forms that these substituents may be in.

Examples of the "linear or branched alkyloxy group having 1 to 6 carbon atoms" or the "cycloalkyloxy group having 5 to 10 carbon atoms" of the "linear or branched alkyloxy group having 1 to 6 carbon atoms and optionally having a substituent" or the "cycloalkyloxy group having 5 to 10 carbon atoms and optionally having a substituent" represented by R₂₆ to R₃₂ in the general formula (5) include those listed above as examples of the "linear or branched alkyloxy group having 1 to 6 carbon atoms" or the "cycloalkyloxy group having 5 to 10 carbon atoms" of the "linear or branched alkyloxy group having 1 to 6 carbon atoms and optionally having a substituent" or the "cycloalkyloxy group having 5 to 10 carbon atoms and optionally having a substituent" represented by R₈ to R₁₉ in the general formula (3), and these groups may be bonded to each other via a linking group such as a single bond, a substituted or unsubstituted methylene group, an oxygen atom, a sulfur atom, or a monosubstituted amino group to form a ring.

Also, these groups may have a substituent, and examples of the substituent include those listed above as examples of the "substituent" of the "linear or branched alkyl group having 1 to 6 carbon atoms and having a substituent", "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

Examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₂₆ to R₃₂ in the general formula (5) include those listed above as examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₈ to R₁₉ in the general formula (3). These groups may be bonded to each other via a single bond, a substituted or unsubstituted methylene group, an oxygen atom, or a sulfur atom to form a ring, and these groups (R₂₆ to R₃₂) and the benzene ring to which these groups (R₂₆ to R₃₂) are directly bonded may be bonded to each other via a linking group such as a substituted or unsubstituted methylene group, an oxygen atom, a sulfur atom, or a monosubstituted amino group to form a ring.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

Examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₃₃ and R₃₄ in the general formula (5) include those listed above as examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₈ to R₁₉ in the general formula (3). These groups may be bonded to each other via a linking group such as a single bond, a substituted or unsubstituted methylene group, an oxygen atom, a sulfur atom, or a monosubstituted amino group to form a ring.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

Examples of the "aryloxy group" of the "substituted or unsubstituted aryloxy group" represented by R₂₆ to R₃₄ in the general formula (5) include to those listed above as examples of the "aryloxy group" of the "substituted or unsubstituted aryloxy group" represented by R₈ to R₁₉ in the general formula (3). These groups may be bonded to each other via a linking group such as a single bond, a substituted or unsubstituted methylene group, an oxygen atom, a sulfur atom, or a monosubstituted amino group to form a ring.

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

Examples of the "aromatic hydrocarbon group", the "aromatic heterocyclic group", or the "fused polycyclic aromatic group" of the "di-substituted amino group having substituents selected from an aromatic hydrocarbon group, an aromatic heterocyclic group, and a fused polycyclic aromatic group" represented by R₂₆ to R₂₉ in the general formula (5) include those listed above as examples of the "aromatic hydrocarbon group", the "aromatic heterocyclic group", or the "fused polycyclic aromatic group" of the "substituted or unsubstituted aromatic hydrocarbon group", the "substituted or unsubstituted aromatic heterocyclic group", or the "substituted or unsubstituted fused polycyclic aromatic group" represented by R₈ to R₁₉ in the general formula (3).

Also, these groups may have a substituent, and examples of the substituent include those listed above as examples of the "substituent" of the "linear or branched alkyl group having 1 to 6 carbon atoms and having a substituent", the "cycloalkyl group having 5 to 10 carbon atoms and having a substituent", or the "linear or branched alkenyl group having 2 to 6 carbon atoms and having a substituent" represented by R₈ to R₁₉ in the general formula (3). The same holds true for the forms that these substituents may be in.

With regard to the "di-substituted amino group having substituents selected from an aromatic hydrocarbon group, an aromatic heterocyclic group, and a fused polycyclic aromatic group" represented by R₂₆ to R₂₉ in the general formula (5), these groups (R₂₆ to R₂₉) may be bonded to each other via the "aromatic hydrocarbon group", the "aromatic heterocyclic group", or the "fused polycyclic aromatic group" included in these groups (R₂₆ to R₂₉), and a single bond, a substituted or unsubstituted methylene group, an oxygen atom, or a sulfur atom to form a ring, and these groups (R₂₆ to R₂₉) and the benzene ring to which these groups (R₂₆ to R₂₉) are directly bonded may be bonded to each other via the "aromatic hydrocarbon group", the "aromatic heterocyclic group", or the "fused polycyclic aromatic group" included in these groups (R₂₆ to R₂₉), and a substituted or unsubstituted methylene group, an oxygen atom, a sulfur atom, or a monosubstituted amino group to form a ring.

Ar₁ in the general formula (1) is preferably a "substituted or unsubstituted aromatic hydrocarbon group" or a "substituted or unsubstituted fused polycyclic aromatic group", more preferably a substituted or unsubstituted phenyl group, biphenylyl group, terphenylyl group, naphthyl group, phenanthrenyl group, anthracenyl group, fluorenyl group, carbazolyl group, indolyl group, dibenzofuranyl group, or dibenzothienyl group, and particularly preferably a substituted or unsubstituted phenyl group. When these groups have a substituent, the substituent is preferably a phenyl group, a biphenylyl group, a terphenylyl group, a naphthyl group, a phenanthrenyl group, or an anthracenyl group, and more preferably a phenyl group or a naphthyl group.

Ar₂ in the general formula (1) is preferably a "substituted or unsubstituted aromatic hydrocarbon group" or a "substituted or unsubstituted fused polycyclic aromatic group", more preferably a substituted or unsubstituted phenyl group, biphenylyl group, terphenylyl group, naphthyl group, phenanthrenyl group, anthracenyl group, or fluorenyl group, and particularly preferably a substituted or unsubstituted phenyl group. When these groups have a substituent, the substituent is preferably a phenyl group, a biphenylyl group, a terphenylyl group, a naphthyl group, a phenanthrenyl group, or an anthracenyl group, and more preferably a phenyl group or a naphthyl group.

Ar₃ in the general formula (1) is preferably a "substituted or unsubstituted aromatic hydrocarbon group" or a "substituted or unsubstituted fused polycyclic aromatic group", more preferably a substituted or unsubstituted phenyl group, biphenylyl group, terphenylyl group, naphthyl group, or fluorenyl group, and particularly preferably a substituted or unsubstituted phenyl group or fluorenyl group. When these groups have a substituent, the substituent is preferably a linear or branched alkyl group having 1 to 6 carbon atoms, a phenyl group, a biphenylyl group, a terphenylyl group, a naphthyl group, a phenanthrenyl group, or an anthracenyl group. In particular, the substituent of a phenyl group is preferably a naphthyl group or a phenanthrenyl group, and the substituent of a fluorenyl group is preferably a linear or branched alkyl group having 1 to 6 carbon atoms.

Moreover, among the compounds represented by the general formula (1), compounds represented by the general formula (1a) or (1b) are preferred.

Ar₄ in the general formula (2) is preferably a phenyl group, a biphenylyl group, a naphthyl group, an anthracenyl group, an acenaphthenyl group, a phenanthrenyl group, a fluorenyl group, an indenyl group, a pyrenyl group, a perylenyl group, a fluoranthenyl group, or a triphenylenyl group, and more preferably a phenyl group, a biphenylyl group, a naphthyl group, an anthracenyl group, a phenanthrenyl group, a pyrenyl group, a fluoranthenyl group, or a triphenylenyl group. Here, the phenyl group preferably has a substituted or unsubstituted fused polycyclic aromatic group as a substituent, and more preferably has a substituent selected from a naphthyl group, an anthracenyl group, a phenanthrenyl group, a pyrenyl group, a fluoranthenyl group, and a triphenylenyl group.

Ar₅ in the general formula (2) is preferably a phenyl group having a substituent. In this case, the substituent is preferably an aromatic hydrocarbon group, such as a phenyl group, a biphenylyl group, or a terphenyl group, or a fused polycyclic aromatic group, such as a naphthyl group, an anthracenyl group, an acenaphthenyl group, a phenanthrenyl group, a fluorenyl group, an indenyl group, a pyrenyl group, a perylenyl group, a fluoranthenyl group, or a triphenylenyl group, and is more preferably a phenyl group, a naphthyl group, an anthracenyl group, a phenanthrenyl group, a pyrenyl group, a fluoranthenyl group, or a triphenylenyl group.

Ar₆ in the general formula (2) is preferably a phenyl group having a substituent. In this case, the substituent is preferably an aromatic hydrocarbon group, such as a phenyl group, a biphenylyl group, or a terphenyl group, or a fused polycyclic aromatic group, such as a naphthyl group, an anthracenyl group, acenaphthenyl group, a phenanthrenyl group, a fluorenyl group, an indenyl group, a pyrenyl group, a perylenyl group, a fluoranthenyl group, or a triphenylenyl group, and is more preferably a phenyl group, a naphthyl group, an anthracenyl group, a phenanthrenyl group, a pyrenyl group, a fluoranthenyl group, or a triphenylenyl group.

In the general formula (2), Ar₅ and Ar₆ may represent the same group; however, this results in an increase in symmetry of the entire molecule, which may facilitate crystallization. Therefore, in view of stability in the form of a film, it is preferable that Ar₅ and Ar₆ represent different groups, and there is no case that both Ar₅ and Ar₆ are hydrogen atoms.

In the general formula (2), it is preferable that either Ar₅ or Ar₆ is a hydrogen atom.

Ar₇ in the general formula (2) is preferably a triazinyl group, a pyridyl group, a pyrimidinyl group, a quinolyl group, an isoquinolyl group, an indolyl group, a quinoxalinyl group, a benzimidazolyl group, a naphthyridinyl group, a phenanthrolinyl group, or an acridinyl group, and more preferably a pyridyl group, a pyrimidinyl group, a quinolyl group, an isoquinolyl group, an indolyl group, a quinoxalinyl group, a benzimidazolyl group, a phenanthrolinyl group, or an acridinyl group.

R₈ to R₁₉ in the general formula (3) are each preferably a deuterium atom, a "linear or branched alkyl group having 1 to 6 carbon atoms and optionally having a substituent", a "linear or branched alkenyl group having 2 to 6 carbon atoms and optionally having a substituent", a "substituted or unsubstituted aromatic hydrocarbon group", or a "substituted or unsubstituted fused polycyclic aromatic group", more preferably a deuterium atom, a phenyl group, a biphenylyl group, a naphthyl group, or a vinyl group. It is also preferable that these groups should be bonded to each other via a single bond to form a fused aromatic ring. In particular, a deuterium atom, a phenyl group, or a biphenylyl group is preferable.

r₈ to r₁₉ in the general formula (3) are each preferably an integer of 0 to 3, and more preferably an integer of 0 to 2.

L₁ to L₃ in the general formula (3) are each preferably a divalent group represented by the structural formula (B) or (D), or a single bond, and more preferably a divalent group represented by the structural formula (B), or a single bond.

n1 of the structural formula (B) in the general formula (3) is preferably 1 or 2, and more preferably 1.

R₂₀ to R₂₅ in the general formula (4) are each preferably a deuterium atom, a "linear or branched alkyl group having 1 to 6 carbon atoms and optionally having a substituent", a "linear or branched alkenyl group having 2 to 6 carbon atoms and optionally having a substituent", a "substituted or unsubstituted aromatic hydrocarbon group", or a "substituted or unsubstituted fused polycyclic aromatic group", and more preferably a deuterium atom, a phenyl group, biphenylyl group, a naphthyl group, or a vinyl group. It is also preferable that these groups should be bonded to each other via a single bond to form a fused aromatic ring. In particular, a deuterium atom, a phenyl group, or a biphenylyl group is preferable.

r₂₀ to r₂₅ in the general formula (4) are each preferably an integer of 0 to 3, and more preferably an integer of 0 to 2.

L₄ in the general formula (4) is preferably a divalent group represented by the structural formula (B), (D), or (G), or a single bond, and more preferably a divalent group represented by the structural formula (D) or (G), or a single bond.

n1 of the structural formula (B) in the general formula (4) is preferably 1 or 2.

A₁ in the general formula (5) is preferably a "divalent group of a substituted or unsubstituted aromatic hydrocarbon" or a single bond, more preferably a divalent group obtained by removing two hydrogen atoms from benzene, biphenyl, or naphthalene, or a single bond, and particularly preferably a single bond.

Ar₉ and Ar₁₀ in the general formula (5) are each preferably a phenyl group, a biphenylyl group, a naphthyl group, a fluorenyl group, an indenyl group, a pyridyl group, a dibenzofuranyl group, or a pyridobenzofuranyl group.

Ar₉ and Ar₁₀ in the general formula (5) may be bonded to each other directly, or via a substituent included in these groups, and a single bond, a substituted or unsubstituted methylene group, an oxygen atom, or a sulfur atom, to form a ring.

Preferably, at least one of R₂₆ to R₂₉ in the general formula (5) is a "di-substituted amino group having substituents selected from an aromatic hydrocarbon group, an aromatic heterocyclic group, and a fused polycyclic aromatic group", and in this case, the "aromatic hydrocarbon group", the "aromatic heterocyclic group", and the "fused polycyclic aromatic group" are preferably a phenyl group, a biphenylyl group, a naphthyl group, a fluorenyl group, an indenyl group, a pyridyl group, a dibenzofuranyl group, or a pyridobenzofuranyl group.

In the general formula (5), another preferable configuration is as follows: adjacent two of R₂₆ to R₂₉, or all of the R₂₆ to R₂₉, are vinyl groups, and adjacent two vinyl groups are bonded to each other via a single bond to form a fused ring, or in other words, adjacent two of R₂₆ to R₂₉ form a naphthalene ring or a phenanthrene ring together with the benzene ring to which these groups are bonded.

In the general formula (5), still another preferable configuration is as follows: any one of R₂₆ to R₂₉ is an "aromatic hydrocarbon group", and this group and the benzene ring to which R₂₆ to R₂₉ are bonded are bonded to each other via a substituted or unsubstituted methylene group, an oxygen atom, or a sulfur atom to form a ring. This configuration particularly preferably fulfills the following conditions: the "aromatic hydrocarbon group" is a phenyl group, and the phenyl group and the benzene ring to which R₂₆ to R₂₉ are bonded are bonded to each other via an oxygen atom or a sulfur atom to form a ring, or in other words, the phenyl group forms a dibenzofuran ring or a dibenzothiophene ring together with the benzene ring to which R₂₆ to R₂₉ are bonded.

In the general formula (5), yet another preferable configuration is as follows: any one of R₃₀ to R₃₂ is an "aromatic hydrocarbon group", and this group and the benzene ring to which R₃₀ to R₃₂ are bonded are bonded to each other via a substituted or unsubstituted methylene group, an oxygen atom, or a sulfur atom to form a ring. This configuration particularly preferably fulfills the following conditions: the "aromatic hydrocarbon group" is a phenyl group, and the phenyl group and the benzene ring to which R₃₀ to R₃₂ are bonded are bonded to each other via an oxygen atom or a sulfur atom to form a ring, or in other words, the phenyl group forms a dibenzofuran ring or a dibenzothiophene ring together with the benzene ring to which R₃₀ to R₃₂ are bonded.

R₃₃ and R₃₄ in the general formula (5) are each preferably a "substituted or unsubstituted aromatic hydrocarbon group", a "substituted or unsubstituted oxygen-containing aromatic heterocyclic group", or a "substituted or unsubstituted fused polycyclic aromatic group", more preferably a phenyl group, a naphthyl group, a phenanthrenyl group, a pyridyl group, a quinolyl group, an isoquinolyl group, or a dibenzofuranyl group, and particularly preferably a phenyl group.

In addition, a configuration is preferable in which R₃₃ and R₃₄ are bonded to each other via a linking group such as a single bond, a substituted or unsubstituted methylene group, an oxygen atom, a sulfur atom, or a monosubstituted amino group to form a ring, and a configuration is particularly preferable in which R₃₃ and R₃₄ are bonded to each other via a single bond to form a ring.

The arylamine compound represented by the general formula (1), which is favorably used in the organic EL element of the present invention, can be used as a constituent material of a hole-transporting layer of the organic EL element. An arylamine compound represented by the general formula (1) has the following properties: (1) good hole-injecting properties, (2) high hole mobility, (3) excellent electron-blocking capability, (4) good stability in the form of a thin film, and (5) excellent heat resistance.

In the organic EL element of the present invention, an arylamine compound is used that has higher hole mobility, superior electron-blocking capability, superior amorphousness, and higher stability in the form of a thin film than a conventional hole-transporting material, and it is thus possible to provide an organic EL element having high efficiency, a low driving voltage, and a long lifespan.

Furthermore, in the present invention, the hole-transporting layer may have a two-layer structure consisting of a first hole-transporting layer and a second hole-transporting layer, the second hole-transporting layer being located on the side adjacent to a light-emitting layer and containing the arylamine compound represented by the general formula (1). In this way, it is possible to make the most of the electron-blocking capability of the arylamine compound to provide an organic EL element having even higher efficiency and an even longer lifespan.

### Brief Description of Drawings

[Fig. 1] Fig. 1 shows structural formulae of Compounds 1-1 to 1-15 as arylamine compounds represented by the general formula (1).
[Fig. 2] Fig. 2 shows structural formulae of Compounds 1-16 to 1-27 as arylamine compounds represented by the general formula (1).
[Fig. 3] Fig. 3 shows structural formulae of Compounds 1-28 to 1-40 as arylamine compounds represented by the general formula (1).
[Fig. 4] Fig. 4 shows structural formulae of Compounds 1-41 to 1-49 as arylamine compounds represented by the general formula (1).
[Fig. 5] Fig. 5 shows structural formulae of Compounds 2-1 to 2-15 as compounds having a pyrimidine ring structure and being represented by the general formula (2).
[Fig. 6] Fig. 6 shows structural formulae of Compounds 2-16 to 2-30 as compounds having a pyrimidine ring structure and being represented by the general formula (2).
[Fig. 7] Fig. 7 shows structural formulae of Compounds 2-31 to 2-45 as compounds having a pyrimidine ring structure and being represented by the general formula (2).
[Fig. 8] Fig. 8 shows structural formulae of Compounds 2-46 to 2-60 as compounds having a pyrimidine ring structure and being represented by the general formula (2).
[Fig. 9] Fig. 9 shows structural formulae of Compounds 2-61 to 2-75 as compounds having a pyrimidine ring structure and being represented by the general formula (2).
[Fig. 10] Fig. 10 shows structural formulae of Compounds 2-76 to 2-87 as compounds having a pyrimidine ring structure and represented by the general formula (2).
[Fig. 11] Fig. 11 shows structural formulae of Compounds 2-88 to 2-99 as compounds having a pyrimidine ring structure and being represented by the general formula (2).
[Fig. 12] Fig. 12 shows structural formulae of Compounds 2-100 to 2-111 as compounds having a pyrimidine ring structure and being represented by the general formula (2).
[Fig. 13] Fig. 13 shows structural formulae of Compounds 2-112 to 2-123 as compounds having a pyrimidine ring structure and being represented by the general formula (2).
[Fig. 14] Fig. 14 shows structural formulae of Compounds 2-124 to 2-126 as compounds having a pyrimidine ring structure and being represented by the general formula (2).
[Fig. 15] Fig. 15 shows structural formulae of Compounds 3-1 to 3-8 as triphenylamine derivatives represented by the general formula (3).
[Fig. 16] Fig. 16 shows structural formulae of Compounds 3-9 to 3-17 as triphenylamine derivatives represented by the general formula (3).
[Fig. 17] Fig. 17 shows structural formulae of Compounds 4-1 to 4-15 as triphenylamine derivatives represented by the general formula (4).
[Fig. 18] Fig. 18 shows structural formulae of Compounds 4-16 to 4-23 as triphenylamine derivatives represented by the general formula (4).
[Fig. 19] Fig. 19 shows structural formulae of Compounds 5-1 to 5-6 as amine derivatives having a fused ring structure and being represented by the general formula (5).
[Fig. 20] Fig. 20 shows structural formulae of Compounds 5-7 to 5-21 as amine derivatives having a fused ring structure and being represented by the general formula (5).
[Fig. 21] Fig. 21 is a diagram showing the configuration of organic EL elements of Examples 10 to 16 and Comparative Examples 1 and 2.

### Description of Embodiments

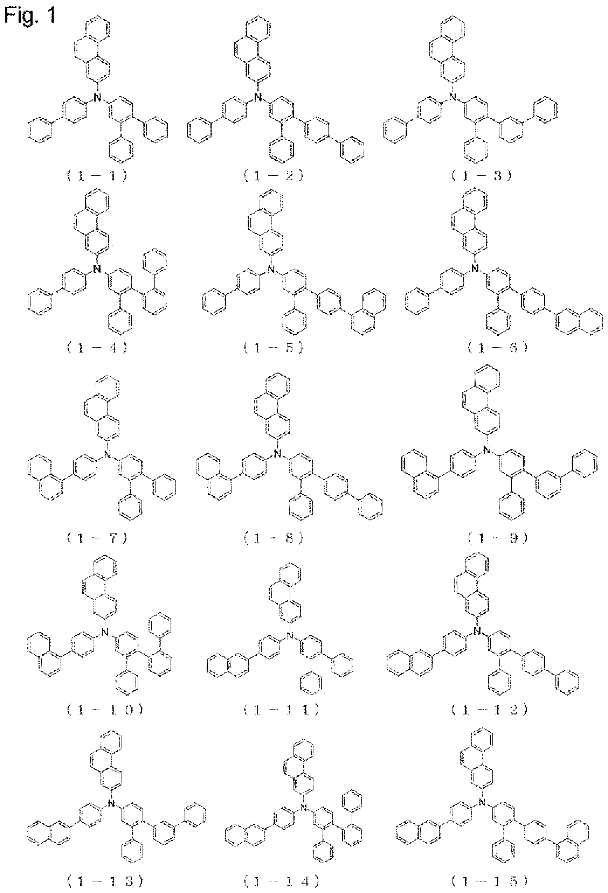

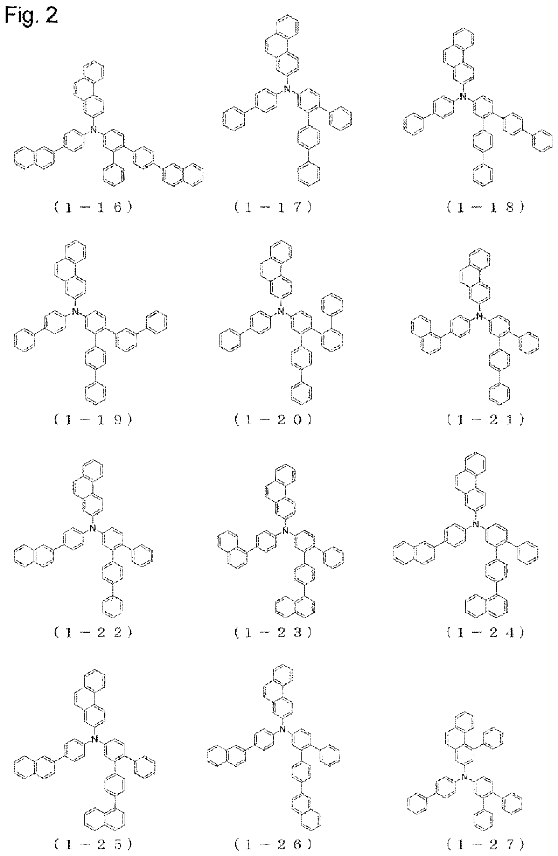

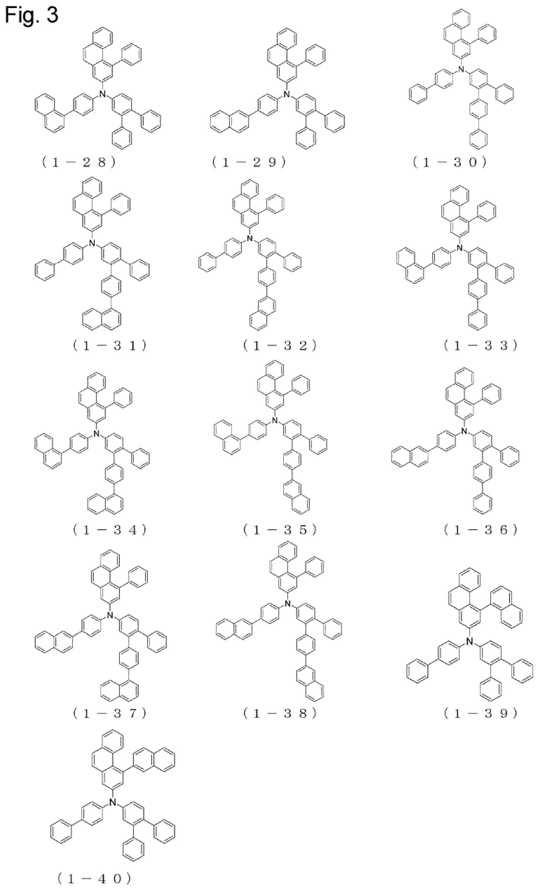

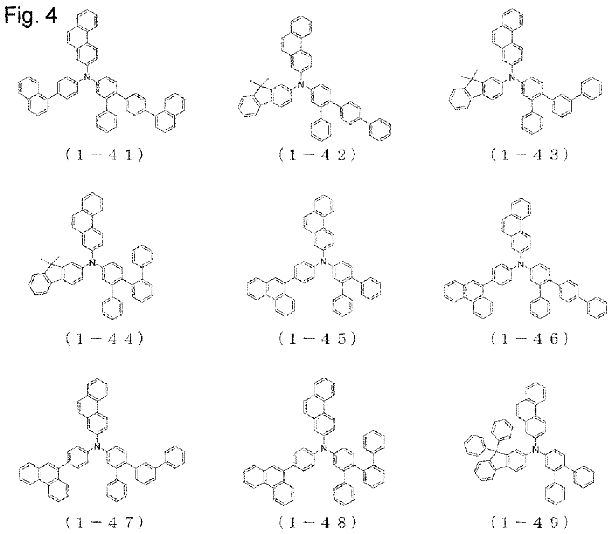

Specific examples of preferred compounds of the arylamine compounds represented by the general formula (1) and favorably used in the organic EL element of the present invention are shown in Figs. 1 to 4, but not limited to thereto.

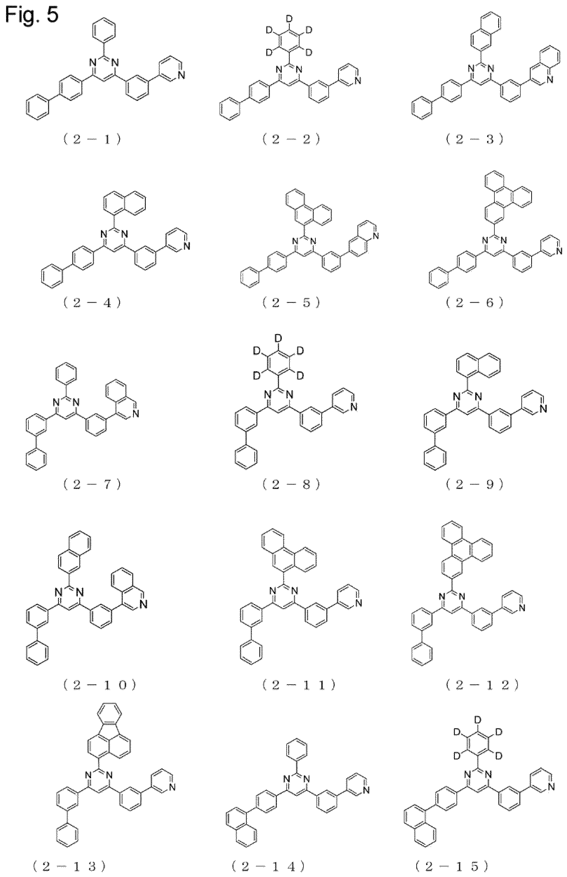

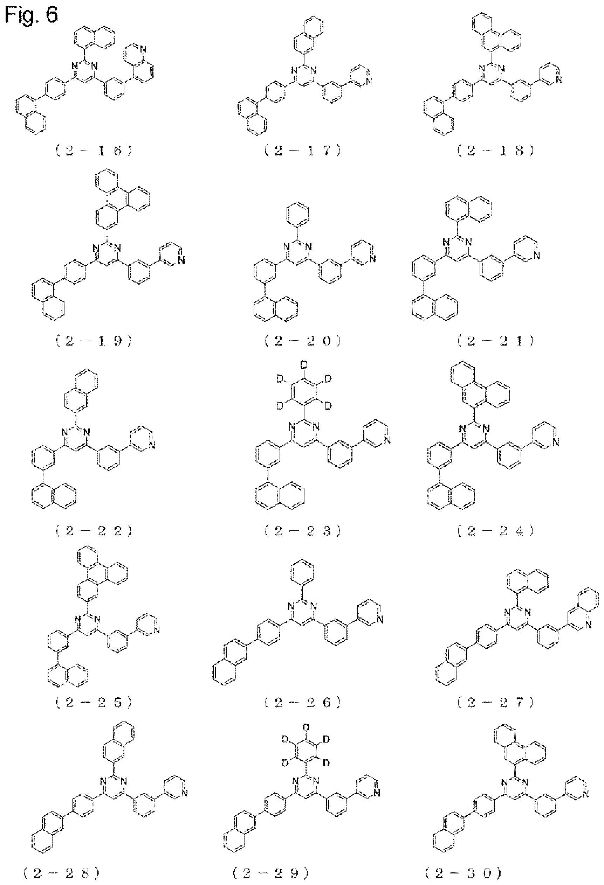

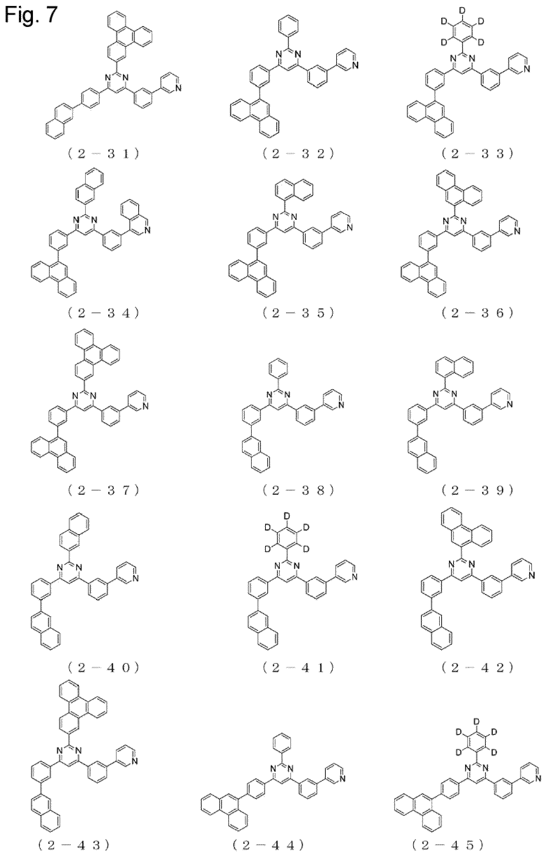

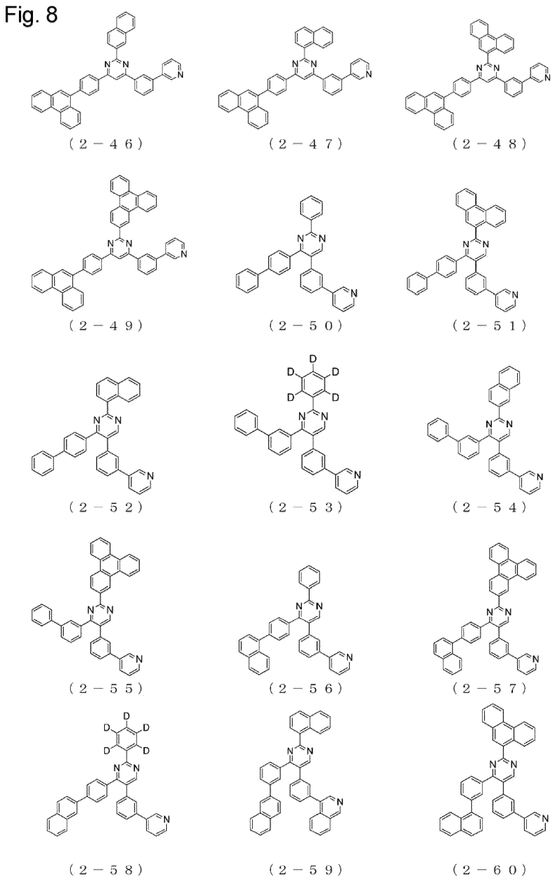

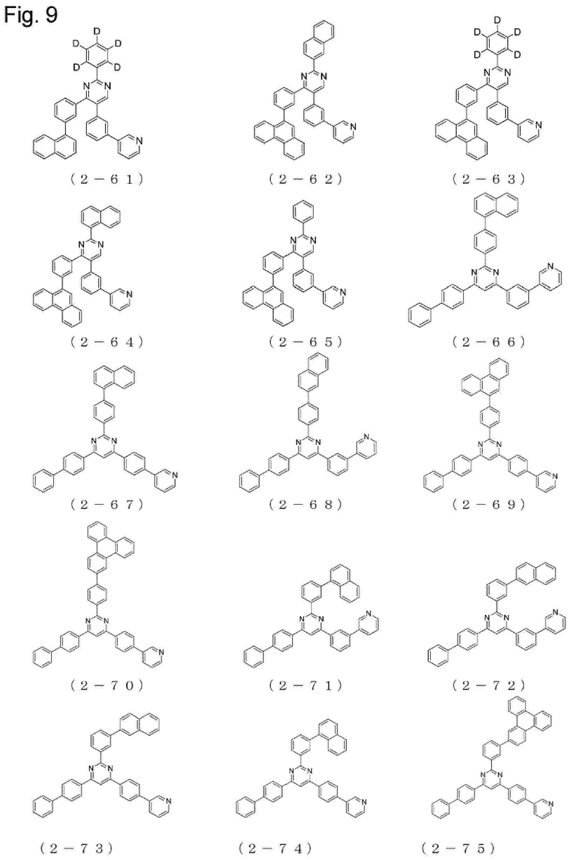

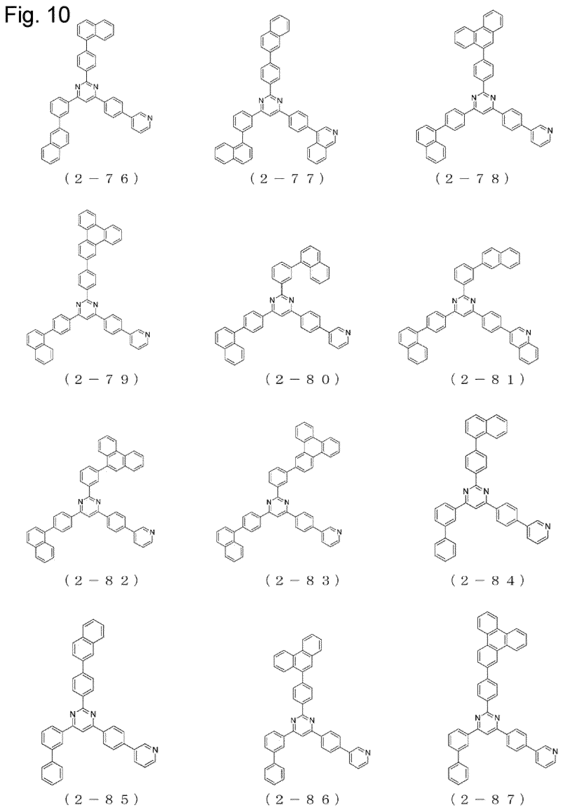

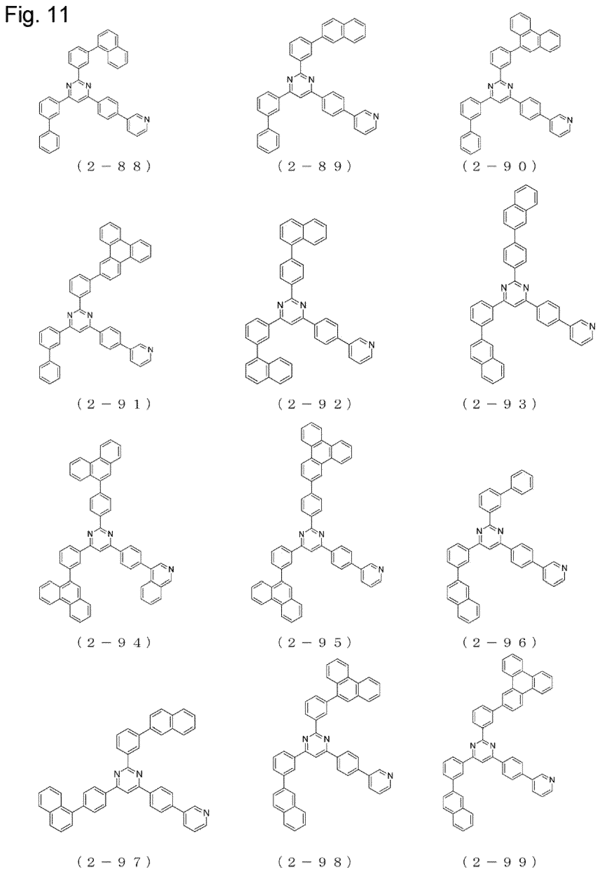

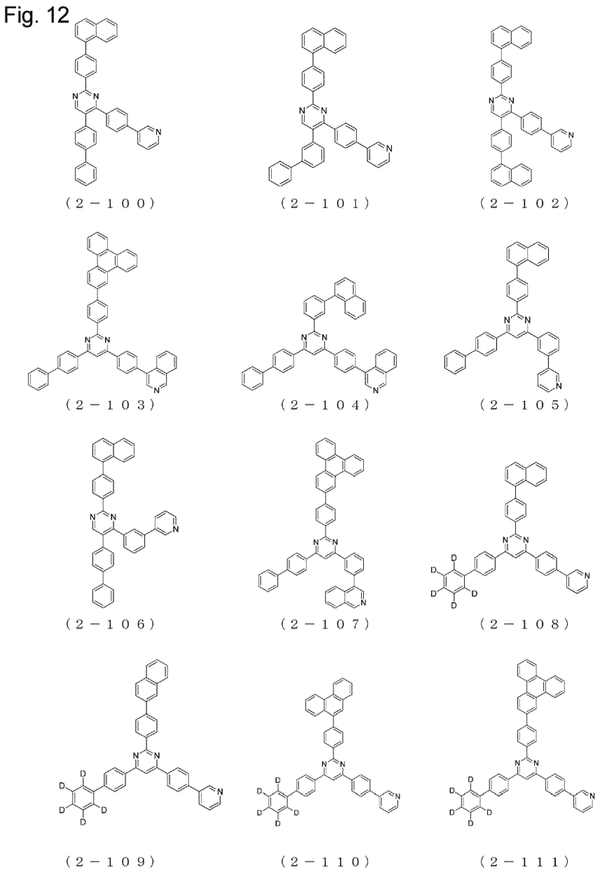

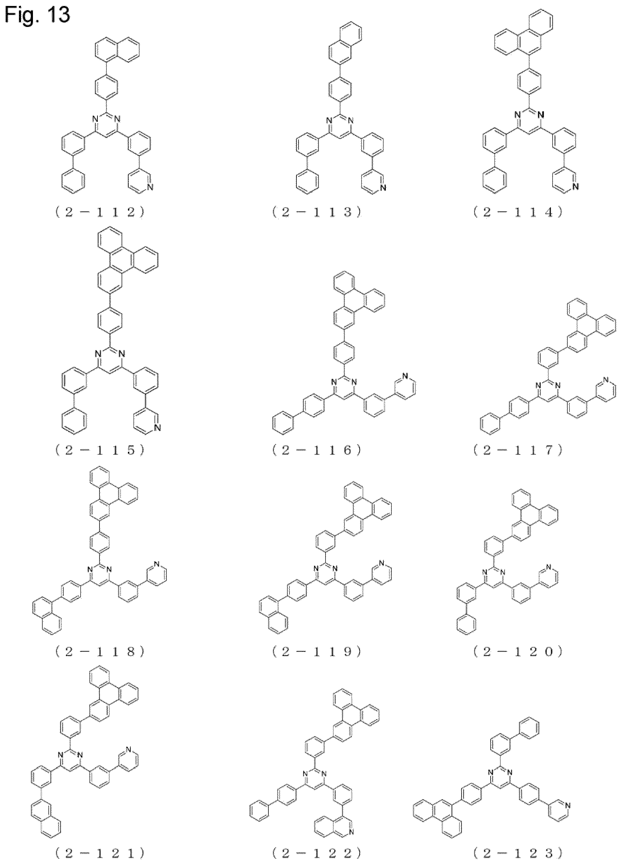

Specific examples of preferred compounds of compounds having a pyrimidine ring structure, being represented by the general formula (2), and favorably used in the organic EL element of the present invention are shown in Figs. 5 to 14, but not limited thereto.

The compounds having a pyrimidine ring structure themselves can be synthesized according to a known method (see Patent Literature 6, for example).

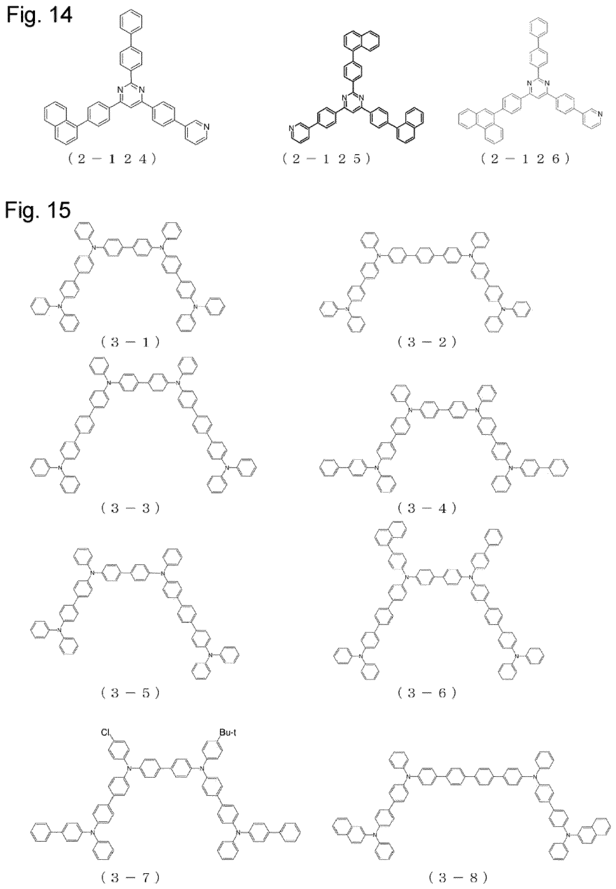

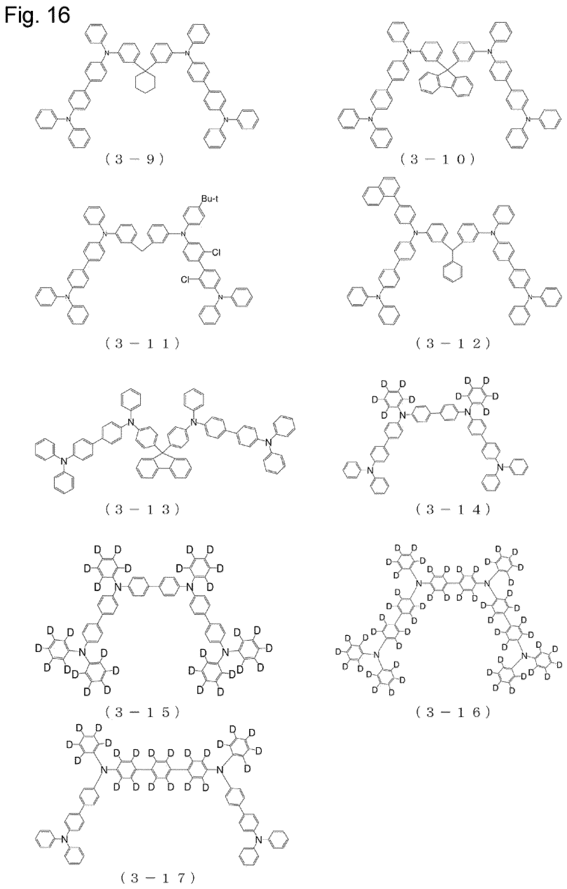

Specific examples of preferred compounds of triphenylamine derivatives represented by the general formula (3) and favorably used in the organic EL element of the present invention are shown in Figs. 15 and 16, but not limited thereto.

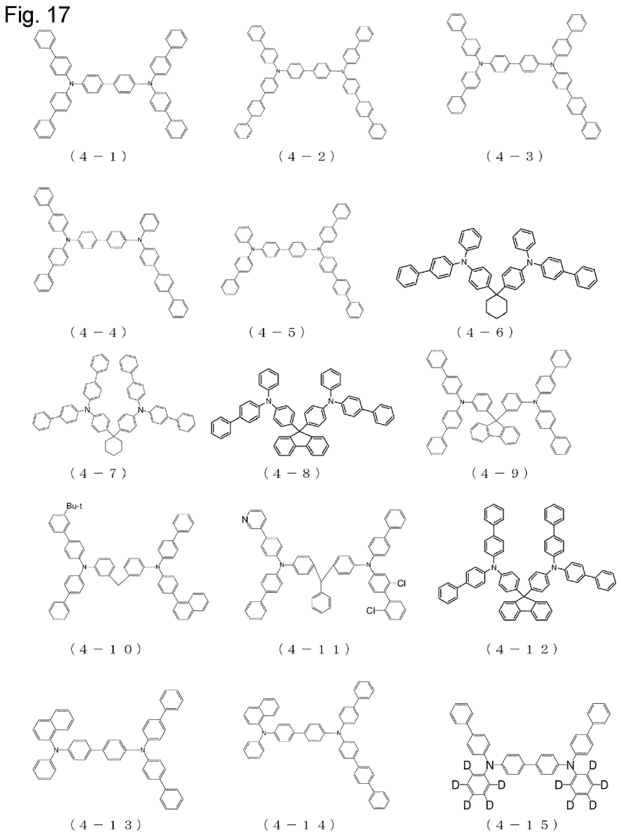

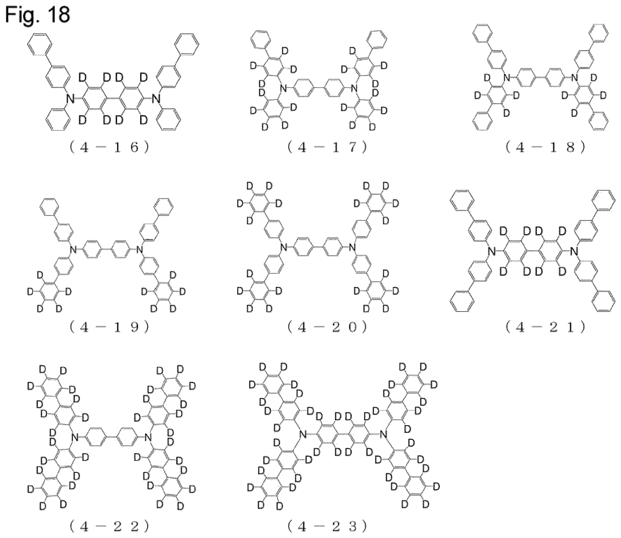

Specific examples of preferred compounds of triphenylamine derivatives represented by the general formula (4) and favorably used in the organic EL element of the present invention are shown in Figs. 17 and 18, but not limited thereto.

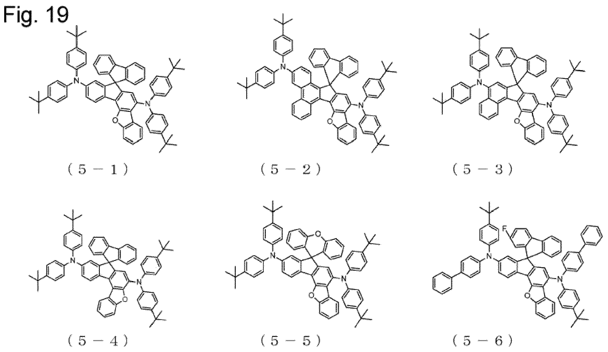

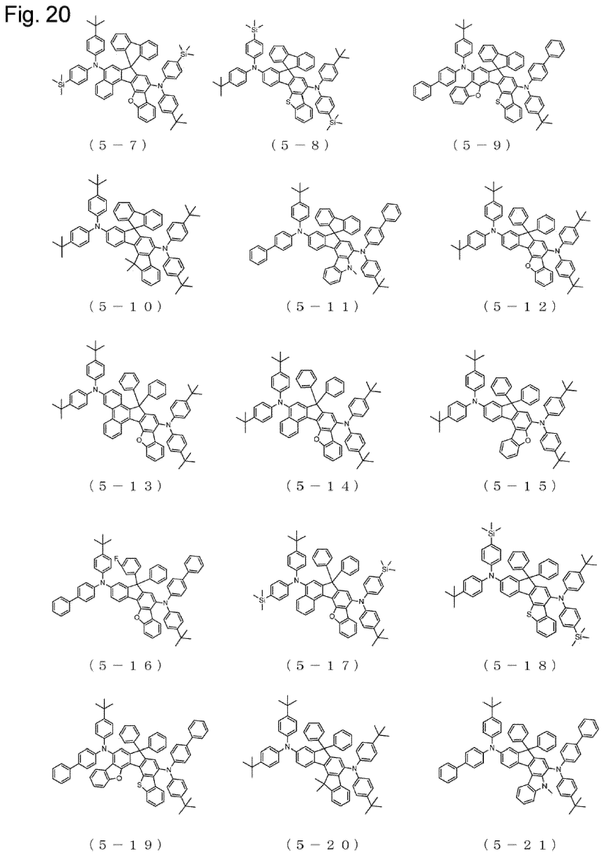

Specific examples of preferred compounds of amine derivatives having a fused ring structure, represented by the general formula (5), and favorably used in the organic EL element of the present invention are shown in Figs. 19 and 20, but not limited thereto.

The amine derivatives having a fused ring structure themselves can be synthesized according to a known method (see Patent Literature 7, for example).

An arylamine compound represented by the general formula (1) can be purified by any known purification method, such as column chromatography, adsorption with silica gel, activated carbon, activated clay, or others, recrystallization or crystallization from a solvent; or sublimation. The compound can be identified through NMR analysis. The physical properties can be measured in terms of melting point, glass transition point (Tg), work function, and others. The melting point is a measure of vapor deposition properties, the glass transition point (Tg) is a measure of stability in the form of a thin film, and the work function is a measure of hole-transporting capability and hole-blocking capability.

Preferably, a compound undergoes purification by, for example, column chromatography, adsorption with silica gel, activated carbon, activated clay, or others, recrystallization or crystallization from a solvent, or sublimation, and then finally sublimation, before it is used for the organic EL element of the present invention.

The melting point and the glass transition point (Tg) can be measured, for example, on the compound in the form of a powder using a high-sensitivity differential scanning calorimeter (DSC3100SA manufactured by Bruker AXS K.K.).

The work function can be measured, for example, on the compound in the form of a thin film with a thickness of 100-nm formed on an ITO substrate using an ionization potential measuring device (PYS-202 manufactured by Sumitomo Heavy Industries, Ltd.).

The organic EL element of the present invention may have a structure in which an anode, a hole-transporting layer, a light-emitting layer, an electron-transporting layer, and a cathode sequentially provided on a substrate; and the structure may further include any of a hole-injecting layer between the anode and the hole-transporting layer; a hole-blocking layer between the light-emitting layer and the electron-transporting layer; and an electron-injecting layer between the electron-transporting layer and the cathode. In these multilayer structures, a single organic layer may perform the functions of two or more layers. For example, a single organic layer may serve as both the hole-injecting layer and the hole-transporting layer, and a single organic layer may serve as both the electron-injecting layer and the electron-transporting layer. Moreover, it is possible to stack two or more organic layers having the same function. Specifically, two hole-transporting layers may be stacked; two light-emitting layers may be stacked; and two electron-transporting layers may be stacked.

With regard to the structure of the organic EL element of the present invention, it is preferable that the hole-transporting layer should have a two-layer structure consisting of the first hole-transporting layer and the second hole-transporting layer, and in this case, it is preferable that the second hole-transporting layer should be adjacent to the light-emitting layer and perform the function of an electron-blocking layer.

An electrode material having a high work function, such as ITO or gold, is used for the anode of the organic EL element of the present invention. Examples of a material used for the hole-injecting layer of the organic EL element of the present invention include starburst triphenylamine derivatives and various triphenylamine tetramers; porphyrin compounds typified by copper phthalocyanine; heterocyclic compounds of acceptor type, such as hexacyanoazatriphenylene; and polymer materials of coating type. These materials can be formed into a thin film using a known method such as vapor deposition, spin coating, or inkjet printing.

The arylamine compound represented by the general formula (1) is used as the material of the hole-transporting layer of the organic EL element of the present invention. Examples of other hole-transporting materials that can be mixed with, or can be used simultaneously with, the arylamine compound represented by the general formula (1) include: benzidine derivatives, such as N,N'-diphenyl-N,N'-di(m-tolyl)-benzidine (TPD), N,N'-diphenyl-N,N'-di(α-naphthyl)benzidine (NPD), and N,N,N',N'-tetrabiphenylyl benzidine; 1,1-bis[4-(di-4-tolylamino)phenyl]cyclohexane (TAPC); triphenylamine derivatives represented by the general formula (3) or (4), and also various triphenylamine derivatives.

These materials may be used singly for film formation, or two or more of these materials may be mixed and used for film formation. In each case, a single layer may be formed. The hole-transporting layer may have a layered structure composed of different layers each formed of a single kind of the materials described above, a layered structure composed of different layers each formed of a mixture of the materials described above, or a layered structure composed of a layer formed of a single kind of the materials described above and a layer formed of a mixture of two or more of the materials described above. These materials can be formed into a thin film using a known method such as vapor deposition, spin coating, or inkjet printing.

Other examples of the material used for the hole-injecting layer or the hole-transporting layer include a material obtained by p-doping a material normally used for these layers with trisbromophenylamine hexachloroantimony or a radialene derivative (see Patent Literature 8, for example); and a polymer compound having the structure of a benzidine derivative, such as TPD, as a partial structure thereof.

When the hole-transporting layer of the organic EL element of the present invention has a two-layer structure consisting of the first hole-transporting layer and the second hole-transporting layer, the arylamine compound represented by the general formula (1) is used as the material of the second hole-transporting layer, which is adjacent to the light-emitting layer. Examples of other hole-transporting materials that can be mixed with, or can be simultaneously used with, the arylamine compound represented by the general formula (1) include: compounds having an electron-blocking effect, such as carbazole derivatives such as 4,4',4"-tri(N-carbazolyl)triphenylamine (TCTA), 9,9-bis[4-(carbazole-9-yl)phenyl]fluorene, 1,3-bis(carbazole-9-yl)benzene (mCP), and 2,2-bis(4-carbazole-9-ylphenyl)adamantane (Ad-Cz); and compounds having a triphenylsilyl group and a triarylamine structure and are typified by 9-[4-(carbazole-9-yl)phenyl]-9-[4-(triphenylsilyl)phenyl]-9H-fluorene.

These materials may be used singly for film formation, or two or more of these materials may be mixed and used for film formation. In each case, a single layer may be formed. The hole-transporting layer may have a layered structure composed of different layers each formed of a single kind of the materials described above, a layered structure composed of different layers each formed of a mixture of the materials described above, or a layered structure composed of a layer formed of a single kind of the materials described above and a layer formed of a mixture of two or more of the materials described above. These materials can be formed into a thin film using a known method such as vapor deposition, spin coating, or inkjet printing.

Examples of a material used for the light-emitting layer of the organic EL element of the present invention include metal complexes of quinolinol derivatives such as Alq₃, and also various types of metal complexes, an anthracene derivative, a bisstyrylbenzene derivative, a pyrene derivative, an oxazole derivative, and a poly(p-phenylene vinylene) derivative. The light-emitting layer may also include a host material and a dopant material. As the host material, an anthracene derivative is preferably used. Other examples of the host material include the above-listed light emitting materials, and also a heterocyclic compound having an indole ring as a partial structure of a fused ring; a heterocyclic compound having a carbazole ring as a partial structure of a fused ring; a carbazole derivative; a thiazole derivative; a benzimidazole derivative; and a polydialkylfluorene derivative. As the dopant material, a pyrene derivative and the amine derivative having a fused ring structure and represented by the general formula (5) are favorably used. Other examples of the dopant material include quinacridone, coumarin, rubrene, perylene, and derivatives thereof; a benzopyran derivative; an indenophenanthrene derivative; a rhodamine derivative; and an aminostyryl derivative.

These materials may be used singly for film formation, or two or more of these materials may be mixed and used for film formation. In each case, a single layer may be formed. The light-emitting layer may have a layered structure composed of different layers each formed of a single kind of the materials described above, a layered structure composed of different layers each formed of a mixture of the materials described above, or a layered structure composed of a layer formed of a single kind of the materials described above and a layer formed of a mixture of two or more of the materials described above.

A phosphorescent emitter can also be used as a light-emitting material. The phosphorescent emitter may be a metal complex of iridium, platinum, or the like, and examples thereof include a green phosphorescent emitter such as Ir(ppy)₃, a blue phosphorescent emitter such as FIrpic or FIr6, and a red phosphorescent emitter such as Btp₂Ir (acac). As a host material in this case, a host material having hole-injecting/transporting capability may be used, including carbazole derivatives such as 4,4'-di(N-carbazolyl)biphenyl (CBP), TCTA, and mCP, and also a host material having electron-transporting capability may be used, including p-bis(triphenylsilyl)benzene (UGH2) and 2,2',2"-(1,3,5-phenylene)-tris(1-phenyl-1H-benzimidazole) (TPBI). Use of these materials enables production of a high-performance organic EL element.

In order to avoid concentration quenching, doping of the host material with a phosphorescent material is preferably performed by co-deposition in an amount within a range of 1 to 30 wt% based on the entire light-emitting layer.

As the light-emitting material, a material that emits delayed fluorescence can also be used, including CDCB derivatives such as PIC-TRZ, CC2TA, PXZ-TRZ, and 4CzIPN, (see Non-Patent Literature 3, for example).

These materials can be formed into a thin film using a known method such as vapor deposition, spin coating, or inkjet printing.

Examples of a material used for the hole-blocking layer of the organic EL element of the present invention include compounds exhibiting a hole-blocking effect including a phenanthroline derivative, such as bathocuproine (BCP); a metal complex of a quinolinol derivative, such as aluminum (III) bis(2-methyl-8-quinolinato)-4-phenylphenolate (hereinafter abbreviated as BAlq); various types of rare-earth complexes; a triazole derivative; a triazine derivative; and an oxadiazole derivative. These materials may also serve as the material of the electron-transporting layer.

These materials may be used singly for film formation, or two or more of these materials may be mixed and used for film formation. In each case, a single layer may be formed. The hole blocking layer may have a layered structure composed of different layers each formed of a single kind of the materials described above, a layered structure composed of different layers each formed of a mixture of the materials described above, or a layered structure composed of a layer formed of a single kind of the materials described above and a layer formed of a mixture of two or more of the materials described above.

The compound having a pyrimidine ring structure and being represented by the general formula (2) is preferably used as the material of the electron-transporting layer of the organic EL element of the present invention. Other examples of a material used for the electron-transporting layer of the organic EL element of the present invention include metal complexes of quinolinol derivatives, such as Alq₃ and BAlq; various types of metal complexes; a triazole derivative; a triazine derivative; an oxadiazole derivative; a pyridine derivative; a pyrimidine derivative; a benzimidazole derivative; a thiadiazole derivative; an anthracene derivative; a carbodiimide derivative; a quinoxaline derivative; a pyridoindole derivative; a phenanthroline derivative; and a silole derivative.

These materials may be used singly for film formation, or two or more of these materials may be mixed and used for film formation. In each case, a single layer may be formed. The electron-transporting layer may have a layered structure composed of different layers each formed of a single kind of the materials described above, a layered structure composed of different layers each formed of a mixture of the materials described above, or a layered structure composed of a layer formed of a single kind of the materials described above and a layer formed of a mixture of two or more of the materials described above.

Examples of a material used for the electron-injecting layer of the organic EL element of the present invention include alkali metal salts such as lithium fluoride and cesium fluoride; alkaline earth metal salts such as magnesium fluoride; metal complexes of quinolinol derivatives such as lithium quinolinol; metal oxides such as aluminum oxide; metals such as ytterbium (Yb), samarium (Sm), calcium (Ca), strontium (Sr), and cesium (Cs). The electron-injecting layer can however be omitted when an electron-transporting layer and a cathode are suitably selected.

Furthermore, a material obtained by n-doping a material normally used for an electron-injecting layer or an electron-transporting layer with a metal such as cesium can be used for the electron-injecting layer or the electron-transporting layer.

Examples of an electrode material used for the cathode of the organic EL element of the present invention include a metal having a low work function, such as aluminum; and an alloy having an even lower work function, such as a magnesium-silver alloy, a magnesium-indium alloy, and an aluminum-magnesium alloy.

Hereinafter, embodiments of the present invention will be described in greater detail by way of Examples. However, the present invention is not limited to Examples below.

### Example 1

### <Synthesis of {4-(naphthalene-2-yl)-phenyl}-(phenanthrene-2-yl)-(1,1':2',1"-terphenyl-5'-yl)amine (Compound (1-11)>

First, 12.0 g of {4-(naphthalene-2-yl)-phenyl}-(1,1':2',1"-terphenyl-5'-yl)amine, 7.6 g of 2-bromophenanthrene, 5.2 g of sodium t-butoxide, and 120 mL of toluene were added to a nitrogen-purged reaction vessel, and a nitrogen gas was allowed to flow therethrough under ultrasonic irradiation for 30 minutes. Then, 0.1 g of palladium acetate and 0.4 g of a 50% (w/v) t-butylphosphine solution in toluene were added, and the resulting system was heated and stirred at 95°C for 16 hours. After insoluble matter was filtered off, and the filtrate was heated, purified by adsorption with activated clay and silica gel at 80°C, and filtered under heating. The resulting filtrate was concentrated, and the residue was subjected to purification through recrystallization from toluene to thereby obtain 8.6 g (yield: 51%) of a yellowish white solid of {4-(naphthalene-2-yl)-phenyl}-(phenanthrene-2-yl)-(1,1':2',1"-terphenyl-5'-yl)amine.

The structure of the obtained yellowish white solid was identified using NMR

In ¹H-NMR (CDCl₃), the following signals of 33 hydrogens were detected. δ (ppm) = 8.64-8.67 (2H), 8.11 (1H), 7.15-7.95 (30H).

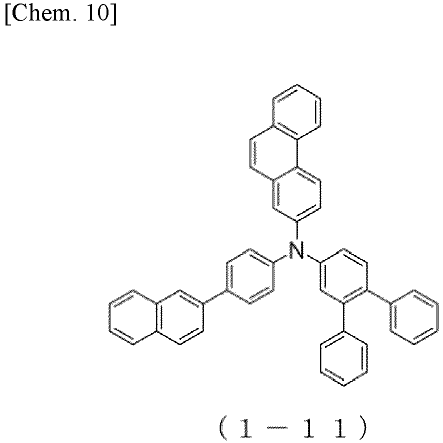

### Example 2

### <Synthesis of {4-(naphthalene-2-yl)-phenyl}-(phenanthrene-2-yl)-(1,1':2',1":3",1"'-quaterphenyl-5'-yl )amine (Compound (1-13)>

7.9 g (yield: 54%) of a yellowish white solid of {4-(naphthalene-2-yl)-phenyl}-(phenanthrene-2-yl)-(1,1':2',1":3",1"'-quaterphenyl-5'-yl )amine was obtained in the same manner as in Example 1, except that {4-(naphthalene-2-yl)-phenyl}-(1,1':2',1":3",1"'-quaterphenyl-5'-yl)amine was used instead of {4-(naphthalene-2-yl)-phenyl}-(1,1':2',1"-terphenyl-5'-yl)amine.

The structure of the obtained yellowish white solid was identified using NMR

In ¹H-NMR (CDCl₃), the following signals of 37 hydrogens were detected. δ (ppm) = 8.65-8.68 (2H), 8.11 (1H), 7.22-7.95 (34H).

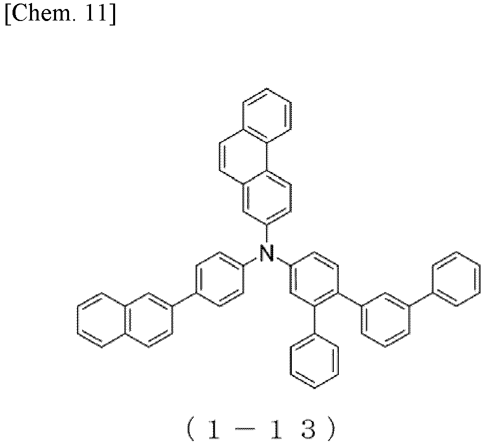

### Example 3

### <Synthesis of {4-(naphthalene-2-yl)-phenyl}-{4"-(naphthalene-1-yl)-(1,1':2',1"-terphenyl)-5'-yl}-(phe nanthrene-2-yl)amine (Compound (1-15)>

11 g (yield: 67%) of a yellowish white solid of {4-(naphthalene-2-yl)-phenyl}-{4"-(naphthalene-1-yl)-(1,1':2',1"-terphenyl)-5'-yl}-(phe nanthrene-2-yl)amine was obtained in the same manner as in Example 1, except that {4-(naphthalene-2-yl)-phenyl}-{4"-(naphthalene-1-yl)-(1,1':2',1"-terphenyl)-5'-yl}-(phe nanthrene-2-yl)amine was used instead of {4-(naphthalene-2-yl)-phenyl}-(1,1':2',1"-terphenyl-5'-yl)amine.

The structure of the obtained yellowish white solid was identified using NMR

In ¹H-NMR (CDCl₃), the following signals of 39 hydrogens were detected. δ (ppm) = 8.66-8.69 (2H), 8.12 (1H), 7.28-7.98 (36H).

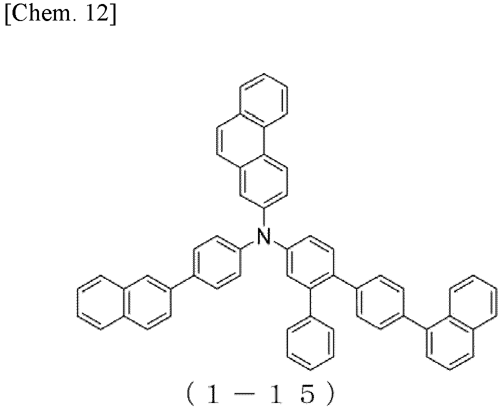

### Example 4

### <Synthesis of {4-(naphthalene-2-yl)-phenyl}-(phenanthrene-2-yl)-(1,1':2',1":4",1"'-quaterphenyl-4'-yl )amine (Compound (1-22)>

12 g (yield: 86%) of a yellowish white solid of {4-(naphthalene-2-yl)-phenyl}-(phenanthrene-2-yl)-(1,1':2',1": 4",1"'-quaterphenyl-4'-yl )amine was obtained in the same manner as in Example 1, except that {4-(naphthalene-2-yl)-phenyl}-(1,1':2',1":4",1"'-quaterphenyl-4'-yl)amine was used instead of {4-(naphthalene-2-yl)-phenyl}-(1,1':2',1"-terphenyl-5'-yl)amine.

The structure of the obtained yellowish white solid was identified using NMR

In ¹H-NMR (CDCl₃), the following signals of 37 hydrogens were detected. δ (ppm) = 8.63-8.64 (2H), 8.10 (1H), 7.21-7.94 (34H).

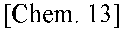

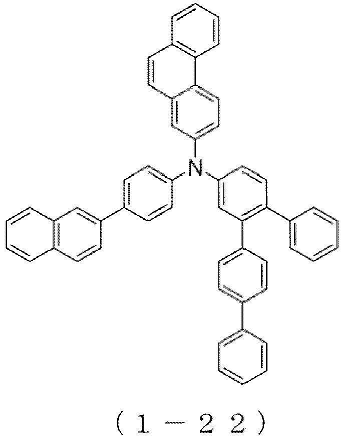

### Example 5

### <Synthesis of {4-(naphthalene-2-yl)-phenyl}-{4"-(naphthalene-1-yl)-(1,1':2',1"-terphenyl)-4'-yl}-(phe nanthrene-2-yl)amine (Compound (1-25)>

11 g (yield: 61%) of a yellowish white solid of {4-(naphthalene-2-yl)-phenyl}-{4"-(naphthalene-1-yl)-(1,1':2',1"-terphenyl)-4'-yl}-(phe nanthrene-2-yl)amine was obtained in the same manner as in Example 1, except that {4-(naphthalene-2-yl)-phenyl}-{4"-(naphthalene-1-yl)-(1,1':2',1"-terphenyl)-4'-yl}amin e was used instead of {4-(naphthalene-2-yl)-phenyl}-(1,1':2',1"-terphenyl-5'-yl)amine.

The structure of the obtained yellowish white solid was identified using NMR

In ¹H-NMR (CDCl₃), the following signals of 39 hydrogens were detected. δ (ppm) = 8.64-8.69 (2H), 8.11 (1H), 7.26-7.97 (36H).

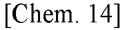

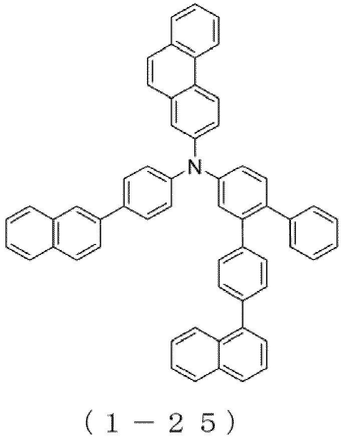

### Example 6

### <Synthesis of (9,9-dimethylfluorene-2-yl)-(phenanthrene-2-yl)-(1,1':2',1":3",1"'-quaterphenyl-5'-yl)a mine (Compound (1-42)>

14.1 g (yield: 70%) of a yellowish white solid of (9,9-dimethylfluorene-2-yl)-(phenanthrene-2-yl)-(1,1':2',1":3",1"'-quaterphenyl-5'-yl)a mine was obtained in the same manner as in Example 1, except that (9,9-dimethylfluorene-2-yl)-(1,1':2',1":4",1"'-quaterphenyl)-4'-yl}amine was used instead of {4-(naphthalene-2-yl)-phenyl}-(1,1':2',1"-terphenyl-5'-yl)amine.

The structure of the obtained yellowish white solid was identified using NMR

In ¹H-NMR (CDCl₃), the following signals of 39 hydrogens were detected. δ (ppm) = 8.63-8.66 (2H), 7.90-7.92 (1H), 7.19-7.77 (30H), 1.52 (6H).

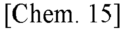

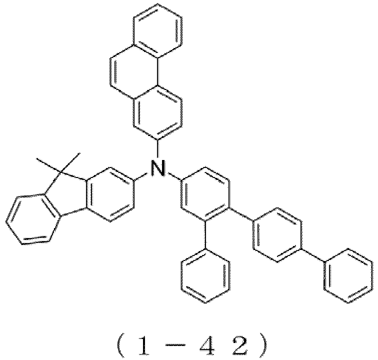

### Example 7

### <Synthesis of {4-(phenanthrene-9-yl)-phenyl}-(phenanthrene-2-yl)-(1,1':2',1"-terphenyl-5'-yl)amine (Compound (1-45)>

9.6 g (yield: 47%) of a white solid of {4-(phenanthrene-9-yl)-phenyl}-(phenanthrene-2-yl)-(1,1':2',1"-terphenyl-5'-yl)amine was obtained in the same manner as in Example 1, except that {4-(phenanthrene-9-yl)-phenyl}-(1,1':2',1"-terphenyl)-4'-yl}amine was used instead of {4-(naphthalene-2-yl)-phenyl}-(1,1':2',1"-terphenyl-5'-yl)amine.

The structure of the obtained white solid was identified using NMR

In ¹H-NMR (CDCl₃), the following signals of 35 hydrogens were detected. δ (ppm) = 8.62-8.86 (4H), 8.13-8.16 (1H), 7.87-7.96 (2H), 7.15-7.82 (28H).

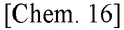

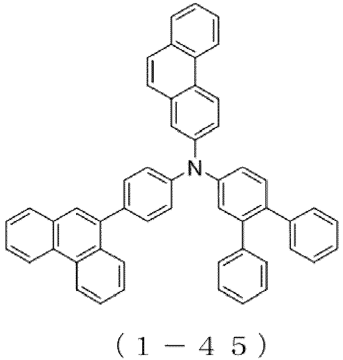

### Example 8

The glass transition point of each of the arylamine compounds represented by the general formula (1) was measured using a high-sensitivity differential scanning calorimeter (DSC3100SA manufactured by Bruker AXS K.K.). Table 1 shows the results.

**Table 1**

| | Glass transition point |
|---|---|
| Compound of Ex. 1 | 112°C |
| Compound of Ex. 2 | 114°C |
| Compound of Ex. 3 | 128°C |
| Compound of Ex. 4 | 127°C |
| Compound of Ex. 5 | 128°C |
| Compound of Ex. 6 | 136°C |
| Compound of Ex. 7 | 131°C |

The arylamine compounds represented by the general formula (1) had a glass transition point of at least 100°C, which means that these arylamine compounds are stable in the form of a thin film.

### Example 9

A vapor-deposited film (thickness: 100 nm) of the arylamine compound represented by the general formula (1) was formed on an ITO substrate, and the work function was measured using an ionization potential measuring device (PYS-202 manufactured by Sumitomo Heavy Industries, Ltd.). Table 2 shows the results.

**Table 2**

| | Work function |
|---|---|
| Compound of Ex. 1 | 5.68 eV |
| Compound of Ex. 2 | 5.67 eV |
| Compound of Ex. 3 | 5.67 eV |
| Compound of Ex. 4 | 5.68 eV |
| Compound of Ex. 5 | 5.70 eV |
| Compound of Ex. 6 | 5.61 eV |
| Compound of Ex. 7 | 5.69 eV |

The arylamine compounds represented by the general formula (1) had a favorable energy level compared with common hole-transporting materials such as NPD and TPD, which have a work function of 5.4 eV, and it is found that these arylamine compounds have good hole-transporting capability.

### Example 10

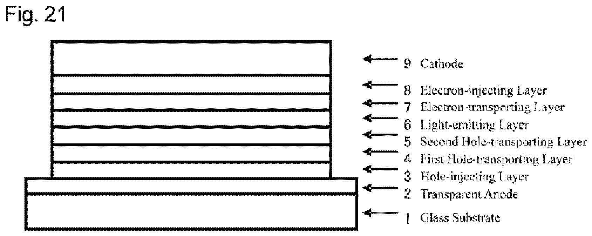

As shown in Fig. 21, an organic EL element was prepared by vapor-depositing, on an ITO electrode formed as a transparent anode 2 on a glass substrate 1, a hole-injecting layer 3, the first hole-transporting layer 4, the second hole-transporting layer 5, a light-emitting layer 6, an electron-transporting layer 7, an electron-injecting layer 8, and a cathode (aluminum electrode) 9 in this order.

Specifically, a glass substrate 1 with an ITO film (thickness: 150 nm) as a transparent anode 2 formed thereon was ultrasonically cleaned in isopropyl alcohol for 20 minutes, and then dried for 10 minutes on a hot plate heated at 200°C. After that, UV/ozone treatment was performed for 15 minutes. Then, the glass substrate with ITO was set inside a vacuum vapor deposition machine, and the pressure was reduced to 0.001 Pa or less. Subsequently, an electron acceptor (Acceptor-1) having the structural formula below and a compound (4-1) having the structural formula below were vapor-deposited so as to coat the transparent anode 2 through binary vapor deposition at vapor deposition rates such that the ratio of the vapor deposition rate of Acceptor-1 to that of the compound (4-1) was 3:97, to thereby form a hole-injecting layer 3 with a thickness of 5 nm.

On this hole-injecting layer 3, the first hole-transporting layer 4 (thickness: 45 nm) made of the compound (4-1) having the structural formula below was formed. On the first hole-transporting layer 4, the second hole-transporting layer 5 (thickness: 10 nm) made of the compound (1-11) having the structural formula below was formed.

On the second hole-transporting layer 5, a compound (5-1) having the structural formula below and a compound (EMH-1) having the structural formula below were vapor-deposited through binary vapor deposition at vapor deposition rates such that the ratio of the vapor deposition rate of the compound (5-1) to that of the compound (EMH-1) was 5:95, to thereby form a light-emitting layer 6 with a thickness of 20 nm.

A compound (3-125) having the structural formula below and a compound (ETM-1) having the structural formula below were vapor-deposited on this light-emitting layer 6 through binary vapor deposition at vapor deposition rates such that the ratio of the vapor deposition rate of the compound (3-125) to that of ETM-1 was 50:50, to thereby form an electron-transporting layer 7 with a thickness of 30 nm.

On this electron-transporting layer 7, an electron-injecting layer 8 (thickness: 1 nm) made of lithium fluoride was formed.

Finally, aluminum was vapor-deposited to a thickness of 100 nm to thereby form a cathode 9. The prepared organic EL element was characterized in the atmosphere at normal temperature. Table 3 collectively shows the measurement results of light emission characteristics when a DC voltage was applied to the prepared organic EL element.

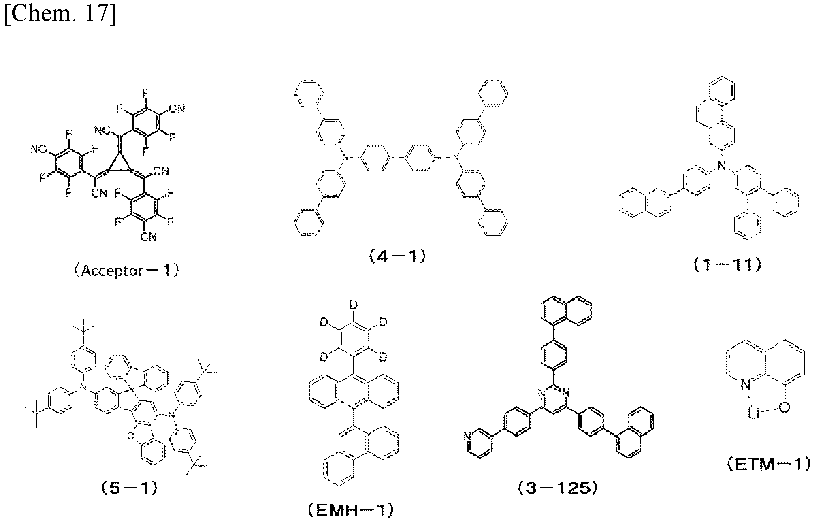

### Example 11

An organic EL element was prepared in the same manner as in Example 10, except that, instead of the compound (1-11) having the structural formula above, the compound (1-13) having the structural formula below was used as the material of the second hole-transporting layer 5. The prepared organic EL element was characterized in the atmosphere at normal temperature. Table 3 collectively shows the measurement results of light emission characteristics when a DC voltage was applied to the prepared organic EL element.

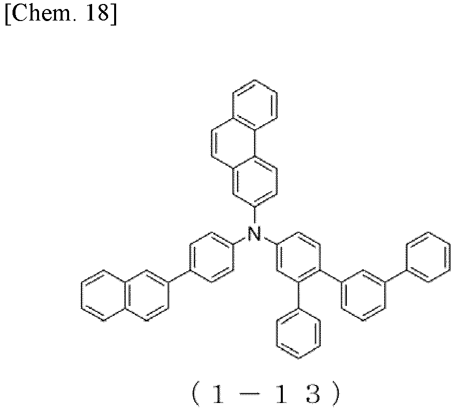

### Example 12

An organic EL element was prepared in the same manner as in Example 10, except that, instead of the compound (1-11) having the structural formula above, the compound (1-15) having the structural formula below was used as the material of the second hole-transporting layer 5. The prepared organic EL element was characterized in the atmosphere at normal temperature. Table 3 collectively shows the measurement results of light emission characteristics when a DC voltage was applied to the prepared organic EL element.

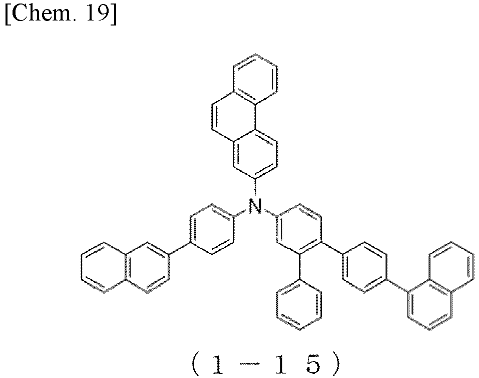

### Example 13

An organic EL element was prepared in the same manner as in Example 10, except that, instead of the compound (1-11) having the structural formula above, the compound (1-22) having the structural formula below was used as the material of the second hole-transporting layer 5. The prepared organic EL element was characterized in the atmosphere at normal temperature. Table 3 collectively shows the measurement results of light emission characteristics when a DC voltage was applied to the prepared organic EL element.

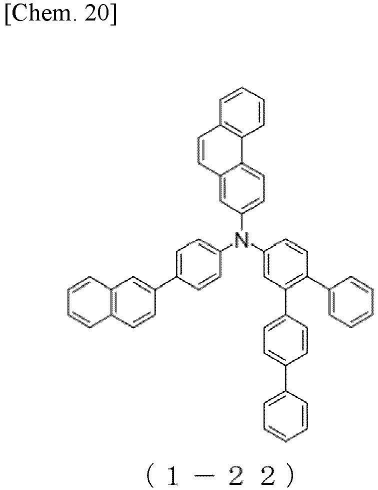

### Example 14

An organic EL element was prepared in the same manner as in Example 10, except that, instead of the compound (1-11) having the structural formula above, the compound (1-25) having the structural formula below was used as the material of the second hole-transporting layer 5. The prepared organic EL element was characterized in the atmosphere at normal temperature. Table 3 collectively shows the measurement results of light emission characteristics when a DC voltage was applied to the prepared organic EL element.

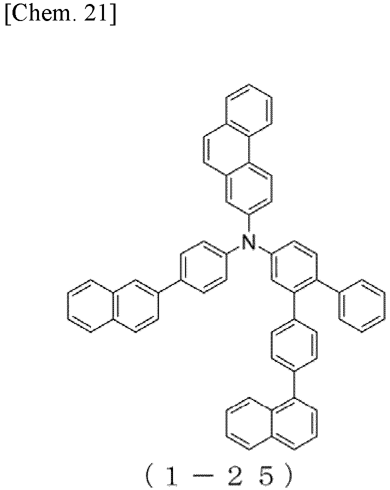

### Example 15

An organic EL element was prepared in the same manner as in Example 10, except that, instead of the compound (1-11) having the structural formula above, the compound (1-42) having the structural formula below was used as the material of the second hole-transporting layer 5. The prepared organic EL element was characterized in the atmosphere at normal temperature. Table 3 collectively shows the measurement results of light emission characteristics when a DC voltage was applied to the prepared organic EL element.

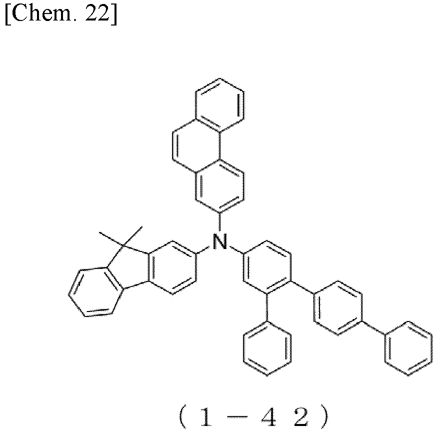

### Example 16

An organic EL element was prepared in the same manner as in Example 10, except that, instead of the compound (1-11) having the structural formula above, the compound (1-45) having the structural formula below was used as the material of the second hole-transporting layer 5. The prepared organic EL element was characterized in the atmosphere at normal temperature. Table 3 collectively shows the measurement results of light emission characteristics when a DC voltage was applied to the prepared organic EL element.

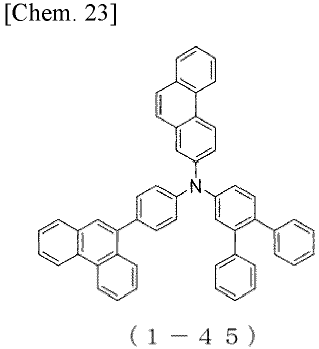

### Comparative Example 1

For comparison, an organic EL element was prepared in the same manner as in Example 10, except that, instead of the compound (1-11) having the structural formula above, a compound (HTM-1) having the structural formula below was used as the material of the second hole-transporting layer 5. The prepared organic EL element was characterized in the atmosphere at normal temperature. Table 3 collectively shows the measurement results of light emission characteristics when a DC voltage was applied to the prepared organic EL element.

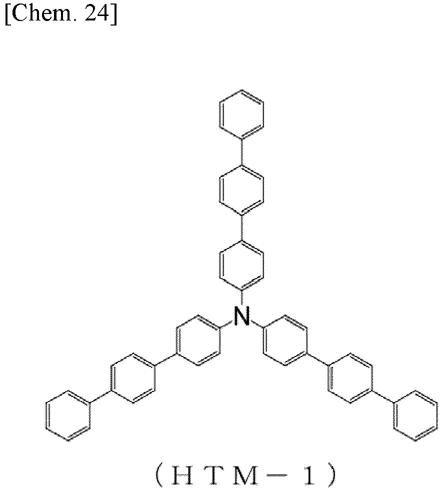

### Comparative Example 2

For comparison, an organic EL element was prepared in the same manner as in Example 10, except that, instead of the compound (1-11) having the structural formula above, a compound (HTM-2) having the structural formula below was used as the material of the second hole-transporting layer 5. The prepared organic EL element was characterized in the atmosphere at normal temperature. Table 3 collectively shows the measurement results of light emission characteristics when a DC voltage was applied to the prepared organic EL element.

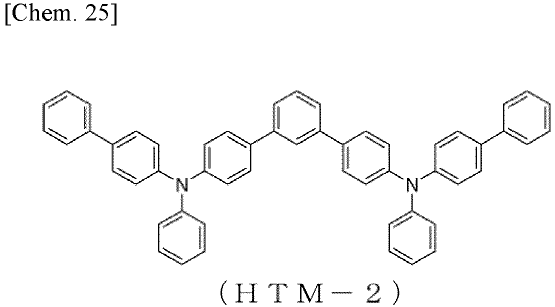

The element lifespan of each of the organic EL elements prepared in Examples 10 to 16 and Comparative Examples 1 and 2 was measured. Table 3 collectively shows the results. The element lifespan was determined as follows: the organic EL element was driven by constant current to emit light at an initial luminance (the luminance when light emission started) of 2,000 cd/m², and the time taken for the luminance to decay to 1,900 cd/m² (corresponding to 95% based on the initial luminance (100%): 95% decay) was determined and defined as the element lifespan.

**Table 3**

| | Second hole-transporting layer | Voltage [V] (@10mA/cm²) | Luminance [cd/m²] (@10mA/cm²) | Luminous efficacy [cd/A] (@10mA/cm²) | Power efficiency [1m/W] (@10mA/cm²) | Element lifespan (95% decay) |
|---|---|---|---|---|---|---|
| Ex. 10 | Compound 1-11 | 3.63 | 862 | 8.62 | 7.46 | 261 hrs. |
| Ex. 11 | Compound 1-13 | 3.63 | 842 | 8.42 | 7.29 | 210 hrs. |
| Ex. 12 | Compound 1-15 | 3.66 | 866 | 8.66 | 7.43 | 264 hrs. |
| Ex. 13 | Compound 1-22 | 3.63 | 830 | 8.30 | 7.18 | 228 hrs. |
| Ex. 14 | Compound 1-25 | 3.64 | 815 | 8.15 | 7.03 | 208 hrs. |
| Ex. 15 | Compound 1-42 | 3.65 | 841 | 8.41 | 7.25 | 216 hrs. |
| Ex. 16 | Compound 1-45 | 3.63 | 825 | 8.25 | 7.15 | 223 hrs. |
| Com. Ex. 1 | HTM-1 | 3.66 | 751 | 7.51 | 6.45 | 160 hrs. |
| Com. Ex. 2 | HTM-2 | 3.65 | 770 | 7.70 | 6.63 | 120 hrs. |

As shown in Table 3, a current of 10 mA/cm² in terms of a current density was passed through the organic EL elements, and at that time, while the organic EL elements of Comparative Examples 1 and 2 had a luminous efficacy of 7.51 to 7.70 cd/A, the organic EL elements of Examples 10 to 16 had a high luminous efficacy of 8.15 to 8.66 cd/A. Also, while the organic EL elements of Comparative Examples 1 and 2 had a power efficiency of 6.45 to 6.63 lm/W, the organic EL elements of Examples 10 to 16 had a high power efficiency of 7.03 to 7.46 lm/W. Furthermore, while the organic EL elements of Comparative Examples 1 and 2 had an element lifespan (95% decay) of 208 to 264 hours, the organic EL elements of Examples 10 to 16 had a longer lifespan of 120 to 160 hours.

As is clear from the foregoing results, it was found that the organic EL element of the present invention, which includes an arylamine compound having high hole mobility and excellent electron-blocking capability, has higher luminous efficacy and a longer lifespan than conventional organic EL elements.

### Industrial Applicability

The organic EL element of the present invention, which includes an arylamine compound having a specific structure, has increased luminous efficacy and also improved durability. Therefore, the organic EL element of the present invention can be applied to uses such as home electric appliances and lighting equipment, for example.

## Claims

1. An organic electroluminescence element having at least an anode, a hole-transporting layer, a light-emitting layer, an electron-transporting layer, and a cathode in this order, the hole-transporting layer comprising an arylamine compound represented by the general formula (1): 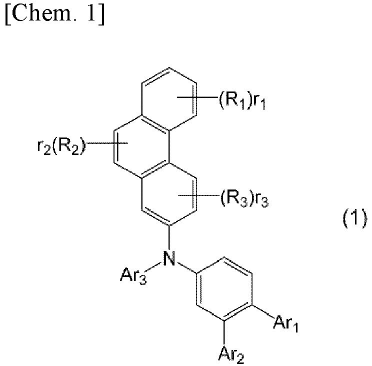
where R₁ to R₃ each independently represent a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
Ar₁ to Ar₃ each independently represent a substituted or unsubstituted aromatic hydrocarbon group, a substituted or unsubstituted aromatic heterocyclic group, or a substituted or unsubstituted fused polycyclic aromatic group; and
r₁ represents an integer of 0 to 4, r₂ represents an integer of 0 to 2, and r₃ represents an integer of 0 to 3,
where, when r₁ is an integer of 2 to 4, when r₂ is 2, or when r₃ is an integer of 2 or 3, a plurality of groups R₁ to R₃ bonded to the same benzene ring are the same or different from each other.

2. The organic electroluminescence element according to claim 1,
wherein the arylamine compound is a compound represented by the general formula (1a): 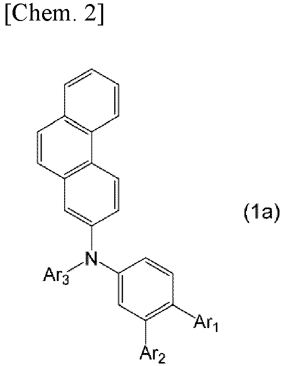 where Ar₁ to Ar₃ are as defined in the general formula (1).

3. The organic electroluminescence element according to claim 2,
wherein Ar₃ is a substituted or unsubstituted phenyl group.

4. The organic electroluminescence element according to claim 1,
wherein the arylamine compound is a compound represented by the general formula (1b): 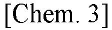 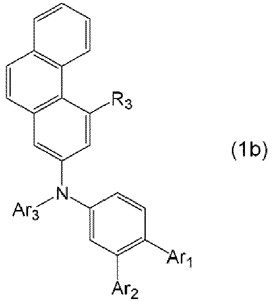 where R₃ and Ar₁ to Ar₃ are as defined in the general formula (1).

5. The organic electroluminescence element according to claim 4,
wherein Ar₃ is a substituted or unsubstituted phenyl group.

6. The organic electroluminescence element according to any one of claims 1 to 5,
wherein the electron-transporting layer comprises a compound having a pyrimidine ring structure and being represented by the general formula (2): 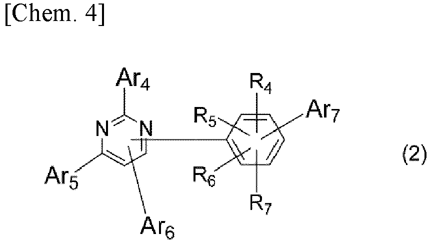
where Ar₄ represents a substituted or unsubstituted aromatic hydrocarbon group or a substituted or unsubstituted fused polycyclic aromatic group;
Ar₅ and Ar₆ each independently represent a hydrogen atom, a substituted or unsubstituted aromatic hydrocarbon group, or a substituted or unsubstituted fused polycyclic aromatic group, where there is no case that both Ar₅ and Ar₆ are hydrogen atoms;
Ar₇ represents a substituted or unsubstituted aromatic heterocyclic group; and
R₄ to R₇ each independently represent a hydrogen atom, a deuterium atom, a fluorine atom, a chlorine atom, a cyano group, a trifluoromethyl group, a linear or branched alkyl group having 1 to 6 carbon atoms, a substituted or unsubstituted aromatic hydrocarbon group, a substituted or unsubstituted aromatic heterocyclic group, or a substituted or unsubstituted fused polycyclic aromatic group.

7. The organic electroluminescence element according to any one of claims 1 to 6,
wherein the hole-transporting layer has a two-layer structure consisting of a first hole-transporting layer and a second hole-transporting layer, and the second hole-transporting layer is adjacent to the light-emitting layer and comprises the arylamine compound.

8. The organic electroluminescence element according to claim 7,
wherein the first hole-transporting layer comprises a triphenylamine derivative which is different from the arylamine compound contained in the second hole-transporting layer, the triphenylamine derivative is a compound having a molecular structure in which two triphenylamine skeletons are linked to each other via a single bond or a divalent hydrocarbon group, and the triphenylamine derivative has two to six triphenylamine skeletons in the molecule as a whole.

9. The organic electroluminescence element according to claim 7 or 8,
wherein the triphenylamine derivative contained in the first hole-transporting layer is a compound represented by the general formula (3): 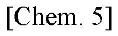 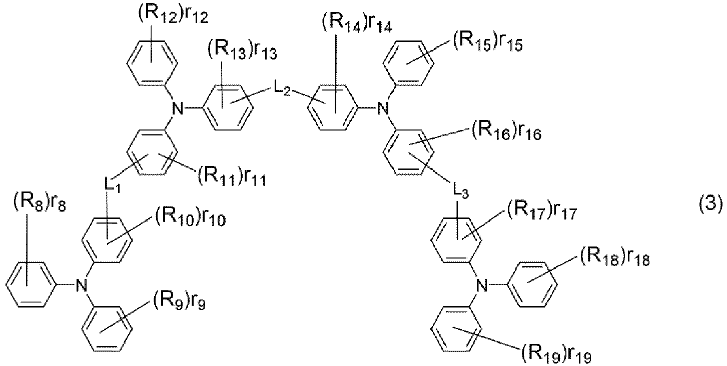
where R₈ to R₁₉ each independently represent a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
r₈, r₉, r₁₂, r₁₅, r₁₈, and r₁₉ each independently represent an integer of 0 to 5, and r₁₀, r₁₁, r₁₃, r₁₄, r₁₆, and r₁₇ each independently represent an integer of 0 to 4,
where, when r₈, r₉, r₁₂, r₁₅, r₁₈, or r₁₉ is an integer of 2 to 5, or when r₁₀, r₁₁, r₁₃, r₁₄, r₁₆, or r₁₇ is an integer of 2 to 4, a plurality of groups R₈ to R₁₉ bonded to the same benzene ring are the same or different from each other, and are optionally bonded to each other via a single bond, a substituted or unsubstituted methylene group, an oxygen atom, or a sulfur atom to form a ring; and
L₁, L₂, and L₃ each independently represent a divalent group represented by any one of the structural formulae (B) to (G), or a single bond: 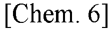 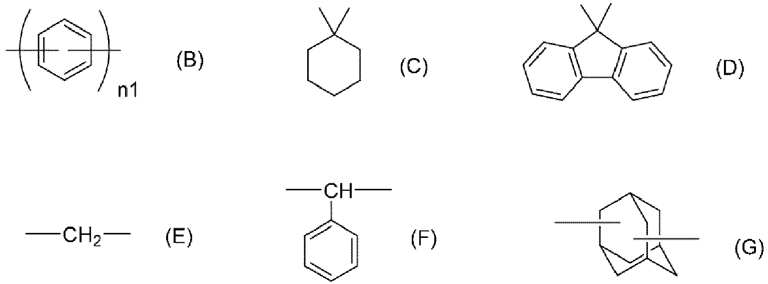 where n1 represents an integer of 1 to 3.

10. The organic electroluminescence element according to claim 7 or 8,
wherein the triphenylamine derivative contained in the first hole-transporting layer is a compound represented by the general formula (4): 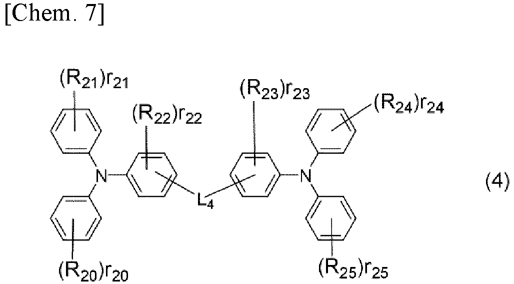
where R₂₀ to R₂₅ each independently represent a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
r₂₀, r₂₁, r₂₄, and r₂₅ each independently represent an integer of 0 to 5, and r₂₂ and r₂₃ each independently represent an integer of 0 to 4,
where, when r₂₀, r₂₁, r₂₄, or r₂₅ is an integer of 2 to 5, or when r₂₂ or r₂₃ is an integer of 2 to 4, a plurality of groups R₂₀ to R₂₅ bonded to the same benzene ring are the same or different from each other, and are optionally bonded to each other via a single bond, a substituted or unsubstituted methylene group, an oxygen atom, or a sulfur atom to form a ring; and
L₄ represents a divalent group represented by any one of the structural formulae (B) to (G), or a single bond: 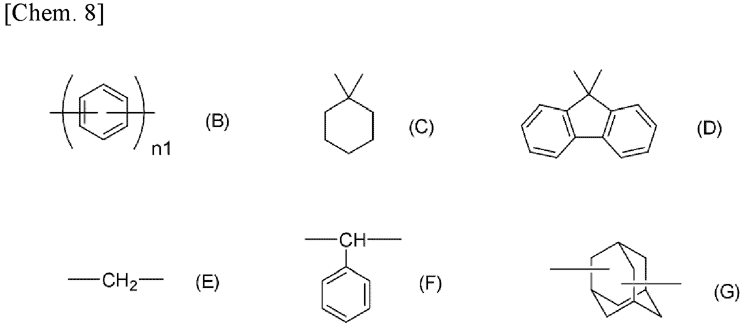 where n1 represents an integer of 1 to 3.

11. The organic electroluminescence element according to any one of claims 1 to 10, wherein the light-emitting layer comprises a blue light-emitting dopant.

12. The organic electroluminescence element according to claim 11,
wherein the blue light-emitting dopant is a pyrene derivative having a pyrene skeleton in the molecule.

13. The organic electroluminescence element according to claim 11,
wherein the blue light-emitting dopant is an amine derivative having a fused ring structure and represented by the general formula (5): 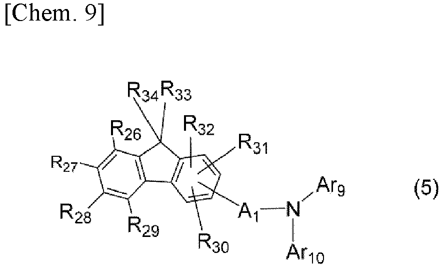
where A₁ represents a divalent group of a substituted or unsubstituted aromatic hydrocarbon, a divalent group of a substituted or unsubstituted aromatic heterocycle, a divalent group of a substituted or unsubstituted fused polycyclic aromatic compound, or a single bond;
Ar₉ and Ar₁₀ each independently represent a substituted or unsubstituted aromatic hydrocarbon group, a substituted or unsubstituted aromatic heterocyclic group, or a substituted or unsubstituted fused polycyclic aromatic group, and are optionally bonded to each other via a single bond, a substituted or unsubstituted methylene group, an oxygen atom, or a sulfur atom to form a ring;
R₂₆ to R₂₉ each independently represent a hydrogen atom, a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, a substituted or unsubstituted aryloxy group, or a di-substituted amino group having substituents selected from an aromatic hydrocarbon group, an aromatic heterocyclic group, and a fused polycyclic aromatic group,
where the groups represented by R₂₆ to R₂₉ are optionally bonded to each other via a single bond, a substituted or unsubstituted methylene group, an oxygen atom, or a sulfur atom to form a ring, and are optionally bonded, via a substituted or unsubstituted methylene group, an oxygen atom, a sulfur atom, or a monosubstituted amino group, to the benzene ring to which R₂₆ to R₂₉ are bonded to form a ring;
R₃₀ to R₃₂ each independently represent a hydrogen atom, a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group,
where the groups represented by R₃₀ to R₃₂ are optionally bonded to each other via a single bond, a substituted or unsubstituted methylene group, an oxygen atom, or a sulfur atom to form a ring, and are optionally bonded, via a substituted or unsubstituted methylene group, an oxygen atom, a sulfur atom, or a monosubstituted amino group, to the benzene ring to which R₃₀ to R₃₂ are bonded to form a ring; and
R₃₃ and R₃₄ each independently represent a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group,
where the groups represented by R₃₃ and R₃₄ are optionally bonded to each other via a single bond, a substituted or unsubstituted methylene group, an oxygen atom, a sulfur atom, or a monosubstituted amino group to form a ring.

14. The organic electroluminescence element according to any one of claims 1 to 13,
wherein the light-emitting layer comprises an anthracene derivative having an anthracene skeleton in the molecule.

15. The organic electroluminescence element according to claim 14,
wherein the light-emitting layer comprises the anthracene derivative as a host material.
